(19) Europäisches Patentamt
European Patent Office
Office européen des brevets

(11) EP 2 408 787 B1

(12) **EUROPÄISCHE PATENTSCHRIFT**

(45) Veröffentlichungstag und Bekanntmachung des Hinweises auf die Patenterteilung:
**07.11.2012 Patentblatt 2012/45**

(21) Anmeldenummer: **10744540.5**

(22) Anmeldetag: **24.06.2010**

(51) Int Cl.:
***C07F 9/02*** (2006.01) ***C07F 1/08*** (2006.01)
***H01L 51/00*** (2006.01)

(86) Internationale Anmeldenummer:
**PCT/EP2010/059012**

(87) Internationale Veröffentlichungsnummer:
**WO 2010/149748 (29.12.2010 Gazette 2010/52)**

(54) **KUPFER-KOMPLEXE FÜR OPTOELEKTRONISCHE ANWENDUNGEN**
COPPER COMPLEXES FOR OPTOELECTRONIC APPLICATIONS
COMPLEXES DE CUIVRE POUR APPLICATIONS OPTOÉLECTRONIQUES

(84) Benannte Vertragsstaaten:
**AL AT BE BG CH CY CZ DE DK EE ES FI FR GB GR HR HU IE IS IT LI LT LU LV MC MK MT NL NO PL PT RO SE SI SK SM TR**

(30) Priorität: **24.06.2009 DE 102009030475**

(43) Veröffentlichungstag der Anmeldung:
**25.01.2012 Patentblatt 2012/04**

(60) Teilanmeldung:
**12171704.5 / 2 502 927**

(73) Patentinhaber: **Cynora GmbH**
**76344 Eggenstein-Leopoldshafen (DE)**

(72) Erfinder:
- **MONKOWIUS, Uwe**
  **A-4020 Linz (AT)**
- **FISCHER, Tobias**
  **93485 Rimbach (DE)**
- **HOFBECK, Thomas**
  **92342 Freystadt (DE)**
- **BAUMANN, Thomas**
  **76133 Karlsruhe (DE)**
- **GRAB, Tobias**
  **76133 Karlsruhe (DE)**
- **YERSIN, Hartmut**
  **93161 Sinzing (DE)**

(74) Vertreter: **Hoppe, Georg Johannes**
**darani Anwaltskanzlei**
**Beuckestrasse 20**
**14163 Berlin (DE)**

(56) Entgegenhaltungen:
**US-A1- 2006 073 360 US-A1- 2006 105 202**

- **XIA ET AL: "Efficient electrophosphorescence from low-cost copper(I) complex" OPTICAL MATERIALS, ELSEVIER SCIENCE PUBLISHERS B.V. AMSTERDAM, NL LNKD- DOI: 10.1016/J.OPTMAT.2005.11.015, Bd. 29, Nr. 6, 7. Januar 2007 (2007-01-07) , Seiten 667-671, XP005824631 ISSN: 0925-3467**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

EP 2 408 787 B1

## Beschreibung

Die Erfindung betrifft Kupfer(I)komplexe der allgemeinen Formel A, insbesondere zur Verwendung in optoelektronischen Bauelementen.

## Einleitung

Zur Zeit zeichnet sich ein drastischer Wandel im Bereich der Bildschirm- und Beleuchtungstechnik ab. Es wird möglich sein, flache Displays oder Leuchtflächen mit einer Dicke von unter 0,5 mm zu fertigen. Diese sind durch viele faszinierende Eigenschaften ausgezeichnet. So werden z. B. Leuchtflächen als Tapeten mit sehr geringem Energieverbrauch realisierbar sein. Ferner werden Farbbildschirme mit bisher nicht erreichbarer Farb-Echtheit, Helligkeit und Blickwinkelunabhängigkeit, mit geringem Gewicht sowie sehr niedrigem Stromverbrauch herstellbar sein. Die Bildschirme werden sich als Mikro-Displays oder Großbildschirme mit mehreren $m^2$ Fläche in starrer Form oder flexibel, aber auch als Transmissions- oder Reflexions-Displays gestalten lassen. Ferner wird es möglich sein, einfache und kostensparende Herstellungsverfahren wie Siebdruck oder Tintenstrahldruck oder Vakuum-Sublimation einzusetzen. Dadurch wird im Vergleich zu herkömmlichen Flachbildschirmen eine sehr preiswerte Fertigung ermöglicht. Diese neue Technik basiert auf dem Prinzip der OLEDs, den Organic Light Emitting Diodes, die in Figur 1 schematisch und vereinfacht dargestellt ist.

Derartige Bauteile bestehen vorwiegend aus organischen Schichten, wie in Fig. 1 schematisch und vereinfacht gezeigt ist. Bei einer Spannung von z. B. 5V bis 10 V treten aus einer leitenden Metallschicht, z. B. aus einer Aluminium-Kathode, negative Elektronen in eine dünne Elektronen-Leitungsschicht und wandern in Richtung der positiven Anode. Diese besteht z. B. aus einer durchsichtigen, aber elektrisch leitenden, dünnen Indium-Zinn-Oxid-Schicht, von der positive Ladungsträger, sog. Löcher, in eine organische Löcher-Leitungsschicht einwandern. Diese Löcher bewegen sich im Vergleich zu den Elektronen in entgegengesetzter Richtung, und zwar auf die negative Kathode zu. In einer mittleren Schicht, der Emitterschicht, die ebenfalls aus einem organischen Material besteht, befinden sich zusätzlich besondere Emitter-Moleküle, an denen oder in deren Nähe die beiden Ladungsträger rekombinieren und dabei zu neutralen, aber energetisch angeregten Zuständen der Emitter-Moleküle führen. Die angeregten Zustände geben dann ihre Energie als helle Lichtemission ab, z. B. in blauer, grüner oder roter Farbe. Auch Weiß-LichtEmission ist realisierbar. Auf die Emitterschicht kann gegebenenfalls auch verzichtet werden, wenn die Emittermoleküle sich in der Loch- oder Elektronen-Leitungsschicht befinden.

Die neuen OLED-Bauelemente lassen sich großflächig als Beleuchtungskörper oder auch äußerst klein als Pixel für Displays gestalten. Entscheidend für den Bau hoch-effektiver OLEDs sind die verwendeten Leuchtmaterialien (Emitter-Moleküle). Diese können in verschiedener Weise realisiert werden, und zwar unter Verwendung rein organischer oder metall-organischer Moleküle sowie von Komplexverbindungen. Es lässt sich zeigen, dass die Lichtausbeute der OLEDs mit metallorganischen Substanzen, den sog. Triplett-Emittern, wesentlich größer sein kann als für rein organische Materialien. Aufgrund dieser Eigenschaft kommt der Weiterentwicklung der metallorganischen Materialien ein wesentlicher Stellenwert zu. Die Funktion von OLEDs ist bereits sehr häufig beschrieben worden.[i-vi] Unter Einsatz von metallorganischen Komplexen mit hoher Emissionsquantenausbeute (Übergänge unter Einbeziehung der untersten Triplett-Zustände zu den Singulett-Grundzuständen) lässt sich eine besonders hohe Effizienz des Devices erzielen. Diese Materialien werden häufig als Triplett-Emitter oder phosphoreszierende Emitter bezeichnet. Diese Erkenntnis ist seit längerem bekannt.[i-v] Für Triplett-Emitter wurden bereits viele Schutzrechte beantragt bzw. erteilt.[vii-xix]

Kupferkomplexe der Form $Cu_2X_2L_4$, $Cu_2X_2L'_2$ und $Cu_2X_2L'$ (L = Phosphan-, Amin-, Imin-Ligand; L' = zweizähniger Phosphan-, Imin-, Amin-Ligand, s.u.) sind bereits aus dem Stand der Technik bekannt. Sie zeigen intensive Lumineszenz bei Anregung mit UV Licht. Die Lumineszenz kann entweder von einem MLCT-, CC (cluster centered)- oder XLCT (halogen-to-ligand-charge-transfer)-Zustand oder einer Kombination dieser stammen. Weitere Einzelheiten zu ähnlichen Cu(I)-Systemen können der Literatur entnommen werden.[xx] Bei dem verwandten $[Cu_2X_2(PPh_3)_2nap]$-Komplex (nap = 1,8-Naphthyridin, X = Br, I) wird ein Übergang zwischen dem Molekülorbital der $\{Cu_2X_2\}$-Einheit (Cu d und Halogen p-Orbitale) und den $\pi^*$-Orbitalen der nap-Gruppe diskutiert.[xxi]

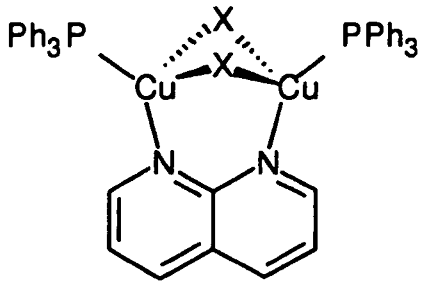

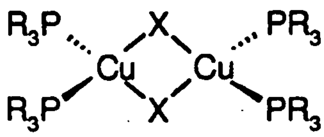

Beispiel einer Struktur der Komplexe der Form Beispiele der Komplexe der Form $Cu_2X_2L_4$ (L = $Cu_2X_2L_2L'$ (L = $PPh_3$, L' = 1,8-Naphthyridin, X $PR_3$, X = Cl, Br, oder I) = Br,17

Triplett-Emitter weisen ein großes Potential zur Lichterzeugung in Displays (als Pixel) und in Beleuchtungsflächen (z. B. als Leuchttapete) auf. Sehr viele Triplett-Emitter-Materialien wurden bereits patentiert und werden mittlerweile auch technologisch in ersten Devices eingesetzt. Die bisherigen Lösungen weisen Nachteile und Probleme auf, und zwar in folgenden Bereichen:

- Langzeitstabilität der Emitter in den OLED-Devices,
- Thermische Stabilität,
- Chemische Stabilität gegenüber Wasser und Sauerstoff,
- Verfügbarkeit wichtiger Emissionsfarben,
- Fertigungstechnische Reproduzierbarkeit,
- Erreichbarkeit einer hohen Effizienz bei hohen Stromdichten,
- Erreichbarkeit sehr hoher Leuchtdichten,
- Hoher Preis der Emittermaterialien,
- Emittermaterialien sind toxisch und
- Synthesen sind aufwendig.

Vor diesem Hintergrund lag der vorliegenden Erfindung die Aufgabe zu Grunde, zumindest einige der oben genannten Nachteile zu überwinden.

**Beschreibung der Erfindung**

Das der Erfindung zu Grunde liegende Problem wird durch die Bereitstellung von Kupfer(I)komp!exen der Form $Cu_2X_2(E\cap N^*)_3$ gelöst, die eine Struktur gemäß Formel A aufweisen:

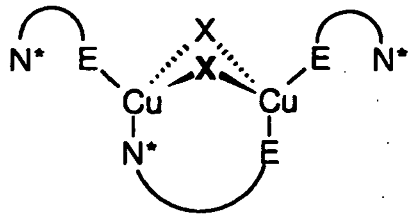

**Formel A**

mit:

X = Cl, Br und/oder I (also unabhängig voneinander, so dass der Komplex zwei gleiche oder zwei unterschiedliche Atome X aufweisen kann)
E = $R_2As$ und/oder $R_2P$,
$N^*\cap E$ = zweibindige Liganden mit E = Phosphanyl/Arsenyl-Rest der Form $R_2E$ (R = Alkyl, Aryl, Alkoxyl, Phenoxyl, Amid); N* = Imin-Funktion. Bei "$\cap$" handelt es sich um ein Kohlenstoffatom. Insbesondere handelt es sich bei E um eine $Ph_2P$-Gruppe (Ph = Phenyl), die Imin-Funktion ist Bestandteil einer aromatische Gruppe (z. B. Pyridyl, Pyrimidyl, Pyridazinyl, Triazinyl, Oxazolyl, Thiazolyl, Imidazolyl, etc.). "$\cap$" ist ebenfalls Bestandteil dieser aromatischen Gruppe. Das Kohlenstoffatom befindet sich sowohl direkt benachbart zum Imin-Stickstoff-Atom als auch zum E-Atom. $N^*\cap E$ kann optional substituiert sein, insbesondere mit Gruppen, die die Löslichkeit des Kupfer(I)komplexes in den gängigen organischen Lösungsmitteln zur OLED-Bauteilherstellung erhöhen. Gängige organische Lösungsmittel umfassen, neben Alkoholen, Ethern, Alkanen sowie halogenierten aliphatischen und aromatischen Kohlenwasserstoffen und alkylierten aromatischen Kohlenwasserstoffen, insbesondere Toluol, Chlorbenzol, Dichlorbenzol, Mesitylen, Xylol, Tetrahydrofuran.

Ein erfindungsgemäßer Kupfer(I)komplex besteht bevorzugt aus drei identischen Liganden $N^*\cap E$, was den Syntheseaufwand und damit die Kosten der Herstellung vermindert. Der große Vorteil bei der Verwendung von Kupfer als Zentralmetall ist dessen niedriger Preis, v. a. im Vergleich zu den sonst bei OLED-Emittem üblichen Metallen wie Re, Os, Ir und Pt. Zusätzlich spricht auch die geringe Toxizität des Kupfers für dessen Verwendung.

Hinsichtlich ihrer Verwendung in optoelektronischen Bauelementen zeichnen sich die erfindungsgemäßen Kupfer(I)komplexe durch einen weiten Bereich von erzielbaren Emissionsfarben aus. Zudem ist die Emissionsquantenausbeute hoch, insbesondere größer als 50 %. Für Emitterkomplexe mit Cu-Zentralion, sind die Emissionsabklingzeiten erstaunlich kurz.

Außerdem sind die erfindungsgemäßen Kupfer(I)komplexe in relativ hohen Emitterkonzentrationen ohne deutliche Quencheffekte verwendbar. Das heißt, im Emitter-Layer können Emitterkonzentrationen von 5 % bis 100 % verwendet werden.

Bevorzugt handelt es sich bei dem Liganden N*∩E um folgende Liganden:

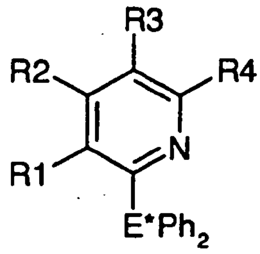
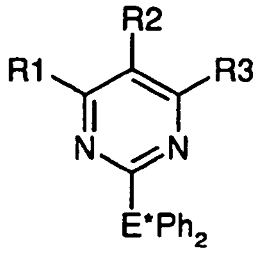
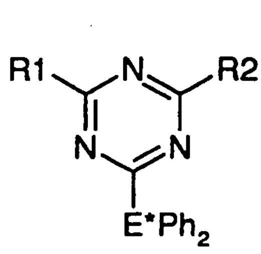
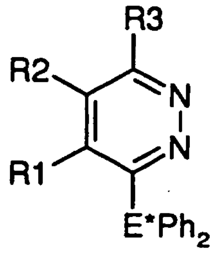

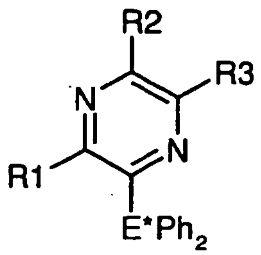
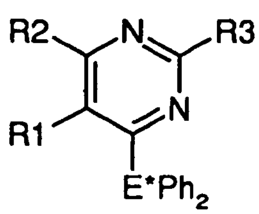
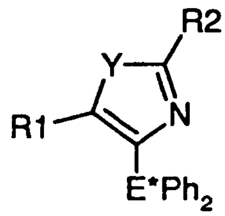
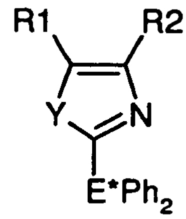

mit

Y = O, S oder NR5
E* = As oder P
R1-R5 können jeweils unabhängig voneinander Wasserstoff, Halogen sein oder Substituenten, die über Sauerstoff bzw. Stickstoff gebunden sind sowie Alkyl-, Aryl-, Heteroaryl-, Alkenyl-, Alkinyl-, Trialkylsilyl- und Triarylsilyl-Gruppen bzw. substituierte Alkyl-, Aryl-, Heteroaryl- und Alkenyl-Gruppen mit Substituenten wie Halogene, niedrige Alkylgruppen. Die Gruppen R1-R5 können auch zu anellierten Ringsystemen führen (z. B. der unten gezeigte Ligand 3).

Die Erfindung betrifft auch ein Verfahren zur Herstellung eines erfindungsgemäßen Kupfer(I)komplexes. Dieses erfindungsgemäße Verfahren weist den Schritt des Durchführens einer Reaktion von N*∩E mit Cu(I)X auf,
wobei
X = Cl, Br oder I (unabhängig voneinander)
N*∩E = ein zweibindiger Ligand mit

E = Phosphanyl/Arsenyl-Rest der Form $R_2E$ (mit R = Alkyl, Aryl, Alkoxyl, Phenoxyl, oder Amid);
N* = Imin-Funktion, die Bestandteil einer aromatische Gruppe ist, die ausgewählt ist aus Pyridyl, Pyrimidyl, Pyridazinyl, Triazinyl, Oxazolyl, Thiazolyl und Imidazolyl,

"∩" = mindestens ein Kohlenstoffatom, das ebenfalls Bestandteil der aromatischen Gruppe ist, wobei sich das Kohlenstoffatom sowohl direkt benachbart zum Imin-Stickstoffatom als auch zum Phosphor- oder Arsenatom befindet.
Der optional am Liganden N*∩E vorhandene mindestens eine Substituent zur Erhöhung der Löslichkeit des Komplexes in organischen Lösungsmitteln ist weiter unten beschrieben.

Die Reaktion wird bevorzugter Weise in Dichlormethan (DCM) durchgeführt. Durch die Zugabe von Diethylether zum gelösten Produkt kann ein Feststoff gewonnen werden. Letzteres kann durch Fällung oder Eindiffusion oder in einem Ultraschall-Bad durchgeführt werden.

Bei der Reaktion von zweizähnigen P∩N*-Liganden (P∩N* = Phosphan-Ligand, Definition s. u.) mit Cu(I)X (X = Cl, Br, I), bevorzugt in Dichlormethan (DCM), bevorzugt bei Raumtemperatur, entsteht - selbst bei einem nicht-stöchiometrischen Verhältnis - überraschend der zweikernige 2:3-Komplex $Cu_2X_2(P∩N^*)_3$, in dem die Cu-Atome durch einen Phosphanligand sowie die beiden Halogenid-Anionen überbrückt werden (G1. 1).

Die Struktur der Formel A ist verwandt mit bekannten Komplexen der Form $Cu_2X_2L_2L'$ bzw. $Cu_2X_2L_4$. Anders

als bei $Cu_2X_2L_2L'$ ist der Komplex jedoch in nur einem Schritt durch Umsetzung von Cu(I)X mit dem zweizähnigen P∩N* Liganden zugänglich. Der Komplex kann durch Fällen mit $Et_2O$ als gelbes oder rotes mikrokristallines Pulver isoliert werden. Einkristalle können durch langsames Eindiffundieren von $Et_2O$ in die Reaktionslösung erhalten werden. Sobald die Komplexe als Pulver oder Kristalle vorliegen, sind sie in gängigen organischen Lösungsmitteln schwer löslich bis unlöslich. Insbesondere bei niedrigen Löslichkeiten wurden Komplexe nur durch Elementar- und Röntgenstrukturanalysen identifiziert.

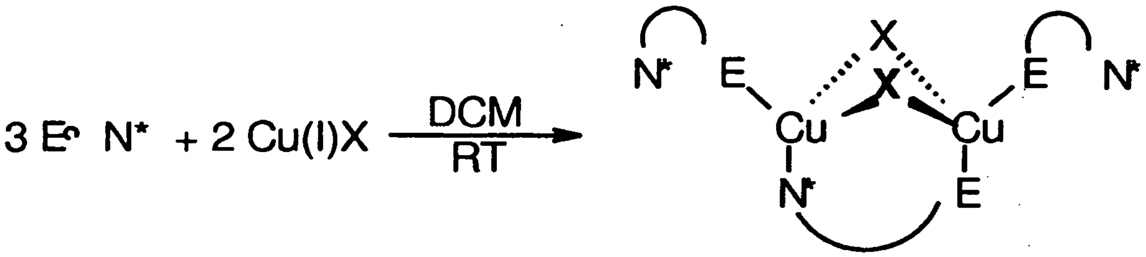


Gl. 1

Hierbei handelt es sich um die oben aufgeführte allgemeine Formel A. Die zweizähnigen E∩N*-Liganden können unabhängig voneinander mindestens einen Substituenten umfassen: Die Substituenten können, jeweils unabhängig voneinander, Wasserstoff, Halogen sein oder Substituenten, die über Sauerstoff bzw. Stickstoff gebunden sind sowie Alkyl-, Aryl-, Heteroaryl-, Alkenyl-, Alkinyl-, Trialkylsilyl- und Triarylsilyl-Gruppen bzw. substituierte Alkyl-, Aryl-, Heteroaryl- und Alkenyl-Gruppen mit Substituenten wie Halogene, niedrige Alkylgruppen. Die Substituenten können auch zu anellierten Ringsystemen führen.

Optional kann das Darstellungsverfahren den Schritt umfassen, dass mindestens ein Ligand N*∩E mit mindestens einem Substituenten zur Erhöhung der Löslichkeit in einem organischen Lösungsmittel substituiert wird, wobei der Substituent in einer Ausführungsform der Erfindung ausgewählt sein kann aus der Gruppe bestehend aus:

- langkettigen, verzweigten oder unverzweigten oder zyklischen Alkylketten einer Länge von C1 bis C30,
- langkettigen, verzweigten oder unverzweigten oder zyklischen Alkoxyketten einer Länge von C1 bis C30,
- verzweigten oder unverzweigten oder zyklischen Perfluoralkylketten einer Länge von C1 bis C30, und
- kurzkettigen Polyethern.

Erfindungsgemäß sind auch Kupfer(I)komplexe, die durch ein derartiges Syntheseverfahren herstellbar sind.

Die Kupfer(I)komplexe der Formel A können erfindungsgemäß als Emitter-Materialien unter Einbeziehung des Triplett-Zustandes in einer Emitterschicht eines Licht-emittierenden optoelektronischen Bauelements eingesetzt werden.

Die Kupfer(I)komplexe der Formel A können erfindungsgemäß auch als Absorber-Materialien in einer Absorberschicht eines optoelektronischen Bauelements eingesetzt werden.

Unter der Bezeichnung "optoelektronische Bauelemente" werden insbesondere verstanden:

- Organische Licht-emittierende Bauteile (organic light emitting diodes, OLEDs)
- Licht-emittierende elektrochemischen Zellen (light emitting electrochemical cells, LECs, LEECs),
- OLED-Sensoren, insbesondere in nicht hermetisch nach außen abgeschirmten Gas- und Dampf-Sensoren,
- organische Solarzellen (organic solar cells, OSCs, organic photovoltaics, OPVs),
- Organische Feldeffekttransistoren und
- Organische Laser.

Der Anteil des Kupfer(I)komplexes in der Emitter- oder Absorber-Schicht in einem derartigen optoelektronischen Bauelement beträgt in einer Ausführungsform der Erfindung 100 %. In einer alternativen Ausführungsform beträgt der Anteil des Kupfer(I)komplexes in der Emitter- oder Absorber-Schicht 1 % bis 99 %.

Vorteilhafter Weise beträgt die Konzentration des Kupfer(I)komplexes als Emitter in optischen Licht emittierenden Bauelementen, insbesondere in OLEDs, zwischen 1 % und 10 %.

Gegenstand der vorliegenden Erfindung sind auch optoelektronische Bauelemente, die einen hier beschriebenen Kupfer(I)komplex aufweisen. Dabei kann das optoelektronische Bauelement ausgeformt sein als ein organisch lichtemittierendes Bauelement, eine organische Diode, eine organische Solarzelle, ein organischer Transistor, als eine organische Licht-emittierende Diode, eine Licht-emittierende elektrochemische Zelle, ein organischer Feldeffekttransistor und als ein organischer Laser.

Weiterhin betrifft die vorliegende Erfindung ein Verfahren zur Herstellung eines optoelektronischen Bauelements, wobei ein erfindungsgemäßer Kupfer(I)komplex der hier beschriebenen Art verwendet wird. Bei diesem Verfahren

wird insbesondere ein erfindungsgemäßer Kupfer(I)komplex auf einen Träger aufgebracht. Dieses Aufbringen kann nass-chemisch, mittels kolloidaler Suspension oder mittels Sublimation erfolgen.

Die vorliegende Erfindung betrifft auch ein Verfahren zur Veränderung der Emissions- und/oder Absorptionseigenschaften eines elektronischen Bauelements. Dabei wird ein erfindungsgemäßer Kupfer(I)komplex in ein Matrixmaterial zur Leitung von Elektronen oder Löchern in ein optoelektronisches Bauelement eingebracht.

Die vorliegende Erfindung betrifft auch die Verwendung eines erfindungsgemäßen Kupfer(I)komplexes, insbesondere in einem optoelektronischen Bauelement, zur Umwandlung von UV-Strahlung oder von blauem Licht in sichtbares Licht, insbesondere in grünes (490-575 nm), gelbes (575-585 nm), oranges (585-650 nm) oder rotes Licht (650-750 nm) (Down-Konversion).

Da die erfindungsgemäßen Kupfer(I)komplexe mit unsubstituierten Liganden N*∩E in einigen organischen Lösungsmitteln z. T. schwer löslich sind, können sie ggf. nicht direkt aus Lösung verarbeitet werden. Bei Lösungsmitteln, die ihrerseits gute Liganden darstellen (Acetonitril, Pyridin) ist zwar eine gewisse Löslichkeit gegeben, jedoch kann eine Änderung der Struktur der Komplexe oder eine Verdrängung der Phosphan- oder Arsan-Liganden unter diesen Bedingungen nicht ausgeschlossen werden. Daher ist nicht klar, ob die Substanzen bei einer Abscheidung auf dem Substrat als $Cu_2X_2(E\cap N^*)_3$ kristallisieren bzw. ob sie in der Matrix in dieser Form molekular vorliegen werden. Aus diesem Grund sollten die Substanzen in einer für die Anwendung in optoelektronischen Bautelementen geeigneten Größe hergestellt bzw. auf diese zerkleinert werden (< 20 nm bis 30 nm, Nanopartikel) oder mittels geeigneter Substituenten löslich gemacht werden.

Die erfindungsgemäßen Kupfer(I)komplexe werden bevorzugt aus Lösung prozessiert, da das hohe Molekulargewicht eine Abscheidung aus dem Vakuum durch Sublimation erschwert. Somit erfolgt die Herstellung der photoaktiven Schichten bevorzugt aus Lösung durch Spincoating oder Schlitzgießverfahren oder mit einem beliebigen Druckverfahren wie Siebdruck, Flexodruck, Offsetdruck oder Ink-Jet-Druck.

Die hier beschriebenen unsubstituierten Kupfer(I)komplexe **4a, 4b, 4c, 5a, 5b, 5c, 6a, 6b**, und **6c** (Definition weiter unten, siehe Beispiele) sind jedoch in den gängigen organischen Lösungsmitteln, außer in Dichlormethan, welches zur OLED-Bauteilherstellung in einer Glovebox nicht verwendet werden sollte, schwer löslich. Das Aufbringen als kolloidale Suspension ist in vielen Fällen sinnvoll (siehe weiter unten), allerdings ist eine technische Verarbeitung der Emittermaterialien in gelöster Form meist technisch einfacher. Daher ist ein weiteres Ziel dieser Erfindung, die Emitter chemisch so zu verändern, dass diese löslich sind. Geeignete Lösungsmittel für die OLED-Bauteilherstellung sind neben Alkoholen, Ethern, Alkanen sowie halogenierten aromatischen und aliphatischen Kohlenwasserstoffen und alkylierten aromatischen Kohlenwasserstoffen, insbesondere Toluol, Chlorbenzol, Dichlorbenzol, Mesitylen, Xylol, Tetrahydrofuran.

Um die Löslichkeit der erfindungsgemäßen Kupfer(I)komplexe in organischen Lösungsmitteln zu verbessern, ist mindestens eine der Strukturen N*∩E in bevorzugter Weise mit mindestens einem Substituenten substituiert. Der Substituent kann ausgewählt sein aus der Gruppe bestehend aus:

- langkettigen, verzweigten oder unverzweigten oder zyklischen Alkylketten mit einer Länge von C1 bis C30, bevorzugt mit einer Länge von C3 bis C20, besonders bevorzugt mit einer Länge von C5 bis C 15,
- langkettigen, verzweigten oder unverzweigten oder zyklischen, Alkoxyketten einer Länge von C1 bis C30, bevorzugt mit einer Länge von C3 bis C20, besonders bevorzugt mit einer Länge von C5 bis C15,
- verzweigten oder unverzweigten oder zyklischen Perfluoralkylketten einer Länge von C1 bis C30, bevorzugt mit einer Länge von C3 bis C20, besonders bevorzugt mit einer Länge von C5 bis C15 und
- kurzkettigen Polyethern, wie z. B. Polymere der Form $(-OCH_2CH_2O-)_n$, mit n < 500. Beispiele hierfür sind Polyethylenglykole (PEG), die als chemisch inerte, wasserlösliche und nicht-toxische Polymere mit einer Kettenlänge von 3-50 Wiederholungseinheiten eingesetzt werden können.

Die Alkylketten oder Alkoxylketten oder Perfluoralkylketten sind in einer bevorzugten Ausführungsform der Erfindung mit polaren Gruppen modifiziert, z. B. mit Alkoholen, Aldehyden, Acetale, Aminen, Amidine, Carbonsäuren, Carbonsäureestern, Carbonsäureamide, Imide, Carbonsäurehalogenide, Carbonsäureanhydride, Ethern, Halogenen, Hydroxamsäuren, Hydrazine, Hydrazone, Hydroxylamine, Laktone, Laktame, Nitrilen, Isocyanide, Isocyanate, Isothiocyanate, Oxime, Nitrosoaryle, Nitroalkyle, Nitroaryle, Phenole, Phosphorsäureestern und/oder Phosphonsäuren, Thiolen, Thioethern, Thioaldehyde, Thioketone, Thioacetale, Thiocarbonsäuren, Thioester, Dithiosäure, Dithiosäureester, Sulfoxide, Sulfone, Sulfonsäure, Sulfonsäureester, Sulfinsäure, Sulfinsäureester, Sulfensäure, Sulfensäureester, Thiosulfinsäure, Thiosulfinsäureester, Thiosulfonsäure, Thiosulfonsäureester, Sulfonamide, Thiosulfonamide, Sulfinamide, Sulfenamide, Sulfate, Thiosulfate, Sultone, Sultame, Trialkylsilyl- und Triarylsilyl-Gruppen sowie Trialkoxysilyl-Gruppen, die eine weitere Erhöhung der Löslichkeit zur Folge haben.

Die Substituenten der Strukturen N*∩E der Kupfer(I)komplexe können an jeder Stelle der Struktur angeordnet sein. Insbesondere ist eine Stellung des Substituenten in ortho-, meta- und/oder para-Stellung zu dem die Koordination zum Cu-Ion ausbildenden Heteroatom möglich. Bevorzugt ist eine Substitution in meta- und/oder para-Stellung.

Eine sehr ausgeprägte Erhöhung der Löslichkeit wird ab mindestens einer C4-Einheit, verzweigt oder unverzweigt oder zyklisch, erreicht. Die Substitution zum Beispiel mit einer linearen C7-Kette in 14 (siehe unten) führt zu einer sehr guten Löslichkeit in z. B. Dichlorbenzol und zur guten Löslichkeit in Chlorbenzol und Toluol.

Ein weiterer Aspekt der Erfindung betriff die Veränderung der Emissionsfarben der Kupfer(I)komplexe mittels elektronenschiebender oder -ziehender Substituenten oder mittels kondensierter N-Heteroaromaten. Die Begriffe elektronenschiebend und elektronenziehend sind dem Fachmann bekannt.

Beispiele für elektronenschiebende Substituenten sind insbesondere:

- Alkyl, -Phenyl, $-CO_2(-)$, -O(-), -NH-Alkylgruppe, $-N-(Alkylgruppe)_2$, $-NH_2$, -OH, -O-Alkylgruppe, -NH(CO)-Alkylgruppe, -O(CO)-Alkylgruppe, -O(CO)-Arylgruppe, -O(CO)-Phenylgruppe, $-(CH)=C-(Alkylgruppe)_2$, -S-Alkylgruppe

Beispiele für elektronenziehende Substituenten sind insbesondere:

- Halogen, -(CO)H, -(CO)-Alkylgruppe, -(CO)O-Alkylgruppe, -(CO)OH, -(CO)Halogenid, $-CF_3$, -CN, $-SO_3H$, $-NH_3(+)$, $-N(Alkylgruppe)_3(+)$, $-NO_2$

Vorteilhafter Weise sind die elektronenschiebenden und -ziehenden Substituenten möglichst weit von der Koordinationsstelle des Liganden entfernt, insbesondere in meta- oder para-Stellung.

Elektronenschiebende Substituenten führen durch Erhöhung des LUMOs zur Veränderung der Emissionsfarbe der Kupfer(I)komplexe in Richtung des blauen Spektralbereichs (Beispiel: 20 (siehe unten), Substitution mittels einer $NMe_2$-Einheit).

Elektronenziehende Substituenten führen durch Absenkung des LUMOs zur Veränderung der Emissionsfarbe der Kupfer(I)komplexe in Richtung des gelbroten Spektralbereichs (Beispiel: 30 (siehe unten), die Einführung eines Fluoratoms in 5-Position des Pyridins).

Somit kann durch geeignete Substitutionswahl innerhalb der Grundstruktur eines Pyridinliganden ein sehr breiter Emissionsfarbbereich eingestellt werden.

Die Veränderung der Emissionsfarben der hier beschriebenen Kupfer(I)komplexe kann auch durch weitere Heteroatome wie N, O, S, sowie mittels kondensierter N-, O- und S-Heteroaromaten erfolgen.

Die Verwendung kondensierter N-Heteroaromaten (beispielsweise Isoquinolin **6**, Benzothiazol **28**, Chinoxalin **34**, siehe Erläuterungen weiter unten) ermöglicht Farbverschiebungen, zum Beispiel in den gelben bis tiefroten Spektralbereich. Die Erhöhung der Löslichkeit von Kupfer(I)komplexen mit kondensierten N-Heteroaromaten kann ebenfalls durch Substitution(en) mit den oben beschriebenen Substituenten, langkettigen (verzweigten oder unverzweigten oder zyklischen) Alkylketten einer Länge von C1 bis C30, bevorzugt mit einer Länge von C3 bis C20, besonders bevorzugt mit einer Länge von C5 bis C15, langkettigen (verzweigten oder unverzweigten oder zyklischen) Alkoxyketten einer Länge von C1 bis C30, bevorzugt mit einer Länge von C3 bis C20, besonders bevorzugt mit einer Länge von C5 bis C15, langkettigen (verzweigten oder unverzweigten oder zyklischen) Perfluoralkylketten einer Länge von C1 bis C30, bevorzugt mit einer Länge von C3 bis C20, besonders bevorzugt mit einer Länge von C5 bis C15 und kurzkettigen Polyethern (Kettenlänge: 3-50 Wiederholungseinheiten) erfolgen.

In einer bevorzugten Ausführungsform weist der erfindungsgemäße Kupfer(I)komplex mindestens einen Substituenten zur Erhöhung der Löslichkeit in einem organischen Lösungsmittel auf und/oder mindestens einen elektronenschiebenden und/oder mindestens einen elektronenziehenden Substituenten. Es ist auch möglich, dass ein die Löslichkeit verbessernder Substituent gleichzeitig entweder ein elektronenschiebender oder -ziehender Substituent ist. Ein Beispiel für einen derartigen Substituenten ist ein dialkyliertes Amin mit elektronenschiebender Wirkung über das Stickstoffatom und löslichkeits-erhöhender Wirkung durch die langkettigen Alkylgruppen.

Mittels einer modularen Synthesestrategie, in der die Einzelbausteine zur Darstellung dieser Liganden in einer Matrix miteinander kombiniert werden, ist die Einführung von unterschiedlich langen, linearen und verzweigten und zyklischen Alkylketten, Alkoxyketten oder Perfluoralkylketten an verschiedenen Positionen der Moleküle möglich. Bevorzugt sind Substitutionen, die weit entfernt sind von der Koordinationsstelle des oder der Liganden N*∩E.

Ausgehend von einem geeigneten Synthesebaustein A werden in analogen Reaktionen unterschiedliche Reaktanden B, C und D unter analogen Reaktionsbedingungen zu chemisch diversen Zielmolekülen AB, AC und AD verknüpft. Hierdurch lassen sich beispielsweise unterschiedlich lange Alkylketten durch Verwendung nukleophiler Substitutionsreaktionen modular an einen geeigneten Pyridinliganden anbringen (Beispiele hierfür sind die Liganden der Komplexe **8, 10, 14,** siehe unten, in denen ein zentraler Baustein unter jeweils gleichen Reaktionsbedingungen mit unterschiedlichen Substituenten substituiert wurde).

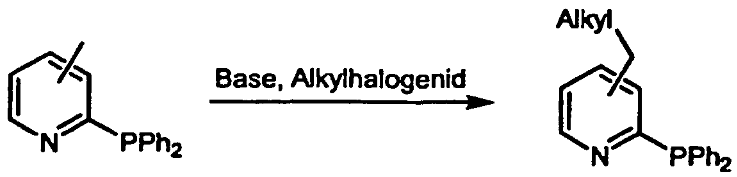


Für die Herstellung der oben genannten Nanopartikel kleiner als 30 nm können mehrere Techniken angewandt werden:[xxii]

Bottom-Up-Prozesse zur Synthese von Nanopartikeln:

- schnelle Injektion der Reaktionslösung in einen großen Überschuss eines geeigneten Fällungsmittel (z. B. Pentan, Diethylether).[xxiii]
- Feine Zerstäubung der Reaktionslösung in einer Vakuumkammer, eventuell unter erhöhter Temperatur (Sprühtrocknung). Dabei verdampft das Lösungsmittel und der Komplex bleibt in feinverteilter Form zurück.
- Im Gefriertrocknungsverfahren werden die Tropfen der Reaktionslösung in einem Kühlmittel (z. B. flüssiger Stickstoff) dispergiert, wobei das Material gefriert. Anschließend wird es im festen Zustand getrocknet.
- Co-Abscheidung der Komplexe und des Matrixmaterials auf dem Substrat direkt aus der Reaktionslösung.
- Synthese im Ultraschall-Bad.

Top-Down-Prozesse zur Zerkleinerung der Substanzen:

- Zerkleinerung durch Hochenergiekugelmühlen.[xxiv]
- Zerkleinerung durch hochintensiven Ultraschall.

Eine Isolierung der benötigten Partikelgröße kann durch Filtration mit geeigneten Filtern oder durch Zentrifugation erreicht werden.

Um eine homogene Verteilung der Nanopartikel in der Matrix (z. B. des im Emitter-Layer verwendeten Matrixmaterials) zu erreichen, wird eine Suspension in einem Lösungsmittel zubereitet, in der sich das Matrixmaterial löst. Durch die üblichen Verfahren (z. B. Spin-Coating, Tintenstrahldruck, etc.) kann mit dieser Suspension das Matrixmaterial und die Nanopartikel auf ein Substrat aufgebracht werden. Um eine Aggregation der Nanopartikel zu vermeiden, kann unter Umständen eine Stabilisierung der Teilchen durch oberflächenaktive Substanzen notwendig sein. Diese sind jedoch so zu wählen, dass die Komplexe nicht aufgelöst werden. Eine homogene Verteilung kann auch durch die oben erwähnte Co-Abscheidung der Komplexe zusammen mit dem Matrixmaterial direkt aus der Reaktionslösung erreicht werden.

Da die beschriebenen Substanzen sogar als Feststoffe eine hohe Emissionsquantenausbeute besitzen, können sie ausgehend von der Reaktionslösung auch direkt als dünne Schicht (100 % Emitterschicht) auf dem Substrat abgeschieden werden.

## Beispiele

In den hier gezeigten Beispielen ist der Ligand E∩N* der allgemeinen Formel A ein Ligand P∩N* (mit E = $Ph_2P$).

Für die Herstellung der Kupferkomplexe wurden die zweizähnigen Phosphanliganden 1 - 3 verwendet:

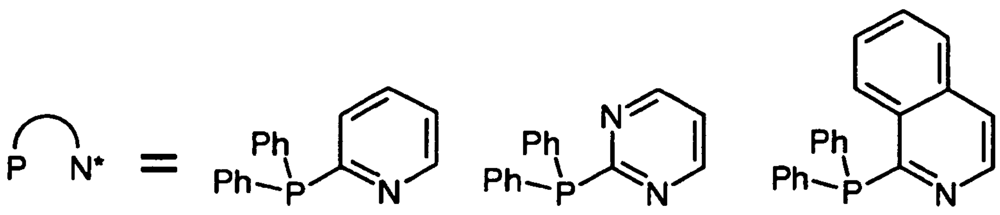

1 2 3

Während 2-Pyridin-diphenyl-phosphan kommerziell erhältlich ist, wurden 2-Pyrimidin- und 1-Isochinolin-diphenyl-phosphan gemäß Gl. 2 hergestellt.

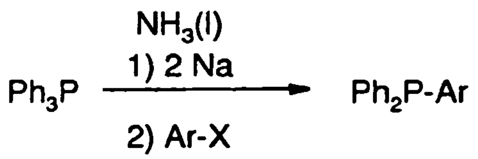


Gl. 2

mit

Ar = py (2); iqn (3)
X=Cl

Die Identitäten der Verbindung **2** und **3** wurden eindeutig durch NMR-Spektroskopie, Massenspektrometrie, Elementaranalysen und Kristallstrukturen (s. Figuren 2 und 3) belegt.

**Beispiele für Komplexe der Form $Cu_2X_2(P{\cap}N^*)_3$**

**I. $P{\cap}N^*$ = $Ph_2Ppy$, 1: $Cu_2X_2(Ph_2Ppy)_3$, X = Cl (4a), Br (4b), I (4c)**

Bei den Verbindungen **4a - 4c** handelt es sich um gelbe, feinkristalline Feststoffe.

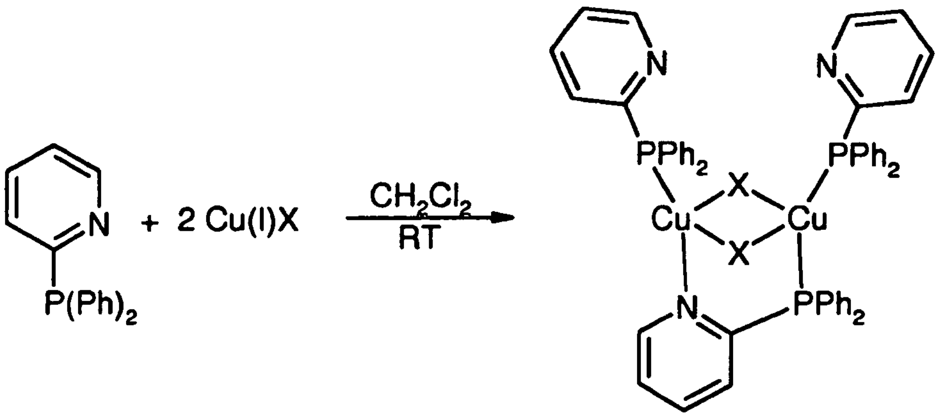


Gl. 3

Charakterisierung:

Elementaranalysen

| | |
|---|---|
| gef.: C 62.48; H 4.40; N 3.90<br>ges.: C 62.01; H 4.29; N 4.25 | **4a** |
| gef.: C 56.89; H 3.93; N 3.90<br>ges.: C 57.04; H 3.92; N 3.78 | **4b** |
| gef.: C 52.96; H 3.94; N 3.50<br>ges.: C 52.32; H 3.62; N 3.59. | **4c** |

Die Kristallstrukturen sind in Fig. 4 **(4a)** bzw. in Fig. 5 **(4c)** gezeigt.
Die Emissionsspektren von **4a - 4c** sind in Fig. 6 gezeigt.

Da bei den Verbindungen **4a** bis **34** ausschließlich ein identischer zweizähniger Ligand im Verhältnis Cu:($N^*{\cap}E$) = 2:3 (E = As, P) eingesetzt wird, erhält man in einem einzigen Schritt in hohen Ausbeuten extrem intensiv lumineszierende Komplexe der Formel A. Dadurch verringert sich der Syntheseaufwand.

**II. P∩N* = $Ph_2Ppym$, 2: $Cu_2X_2(Ph_2Ppym)_3$, X = Cl (5a), Br (5b), I (5c)**

Bei **5a - 5c** handelt es sich um gelbe, feinkristalline Feststoffe.

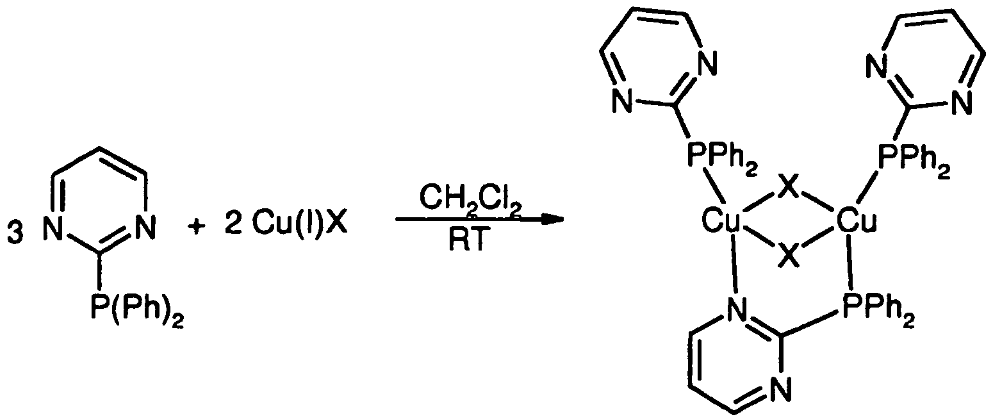


Gl. 4

Charakterisierung:

Elementaranalysen

| | |
|---|---|
| gef.: C 58.45; H 4.12; N 8.43<br>ges.: C 58.19; H 3.97; N 8.48. | **5a** |
| gef.: C 53.24; H 3.53; N 7.76<br>ges.: C 53.40; H 3.64; N 7.78. | **5b** |
| gef.: C 47.73; H 3.44; N 6.75<br>ges.: C 49.12; H 3.35; N 7.16 | **5c** |

Die Kristallstruktur ist in **Fig. 7 (5c)** dargestellt.
Die Emissionsspektren von **5a - 5c** sind in Fig. 8 gezeigt.

**III. P∩N* = $Ph_2Piqn$, 3: $Cu_2X_2(Ph_2Piqn)_3$, X = Br (66), I (6c)**

**6b** und **6c** sind rote, feinkristalline Feststoffe.

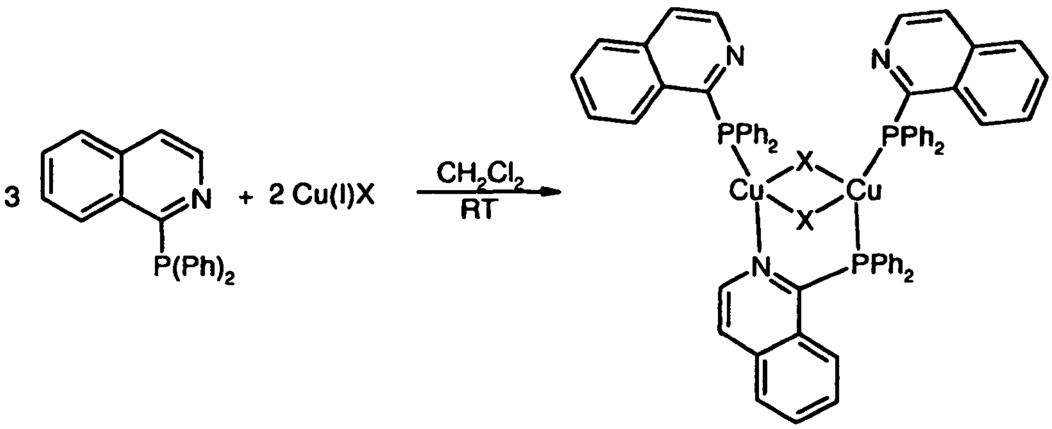


Gl. 5

Charakterisierung:

Elementaranalysen

| | |
|---|---|
| gef.: C 60.29; H 4.08; N 3.23 (mit einem Molekül DCM)<br>ges.: C 59.14; H 2.95; N 3.23 | **6b** |
| gef.: C 53.99; H 3.21; N 2.91 (mit einem Molekül DCM)<br>ges.: C 55.15; H 2.75; N 3.01 | **6c** |

Die Kristallstruktur ist in Fig. 9 (**6c**) wiedergegeben.
Das Emissionsspektrum von **6c** ist in Fig. 10 gezeigt. Fig. 11 reproduziert das Emissions-Abklingverhalten.

**IV. P∩N* = $Ph_2Ppic$, 7: $Cu_2I_2(Ph_2Ppic)_3$, 8**

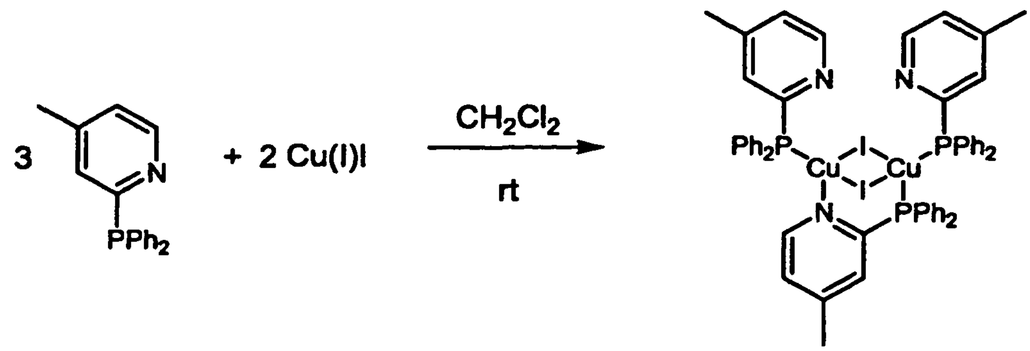


Bei der Verbindung **8** handelt es sich um einen gelben, feinkristallinen Feststoff.

Charakterisierung:

Elementaranalyse:
gef.: C 53.09; H 3.95; N 3.39
ges.: C 53.48; H 3.99; N 3.46

Die Kristallstruktur ist in Fig. 14A (**8**) dargestellt.
Das Emissionsspektrum von **8** ist in Fig. 14B gezeigt.

**v. P∩N* = $Ph_2P(iBupy)$, 9: $Cu_2I_2(Ph_2P(iBupy))_3$,10**

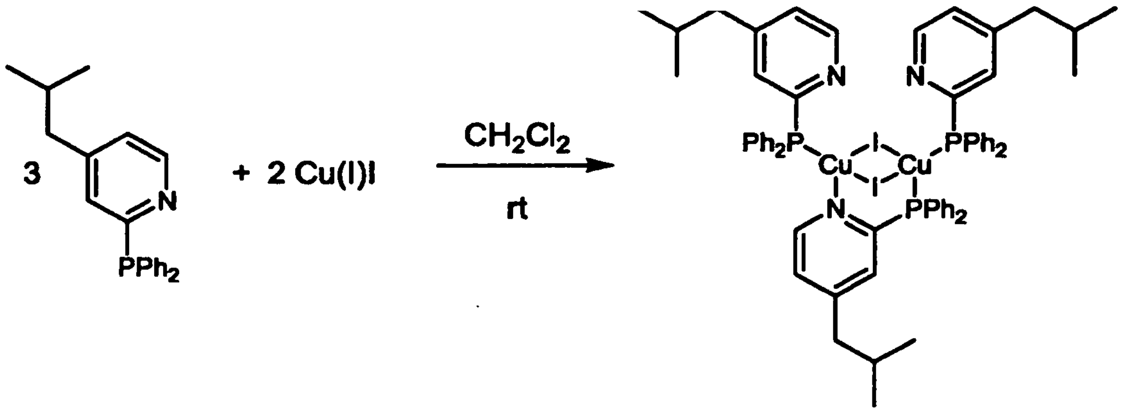


Bei der Verbindung **10** handelt es sich um einen gelben, feinkristallinen Feststoff. Durch Einführung der Isobutyleinheit als Substituent der Liganden E∩N* liegt die Löslichkeit bei für die OLED-Bauteilherstellung ausreichenden 20-30 mg Komplex pro mL Dichlorbenzol (ohne Substituent kaum Löslichkeit in Dichlorbenzol).

Charakterisierung:

Elementaranalyse:
gef.: C 56.72; H 4.96; N 3.10
ges.: C 56.51; H 4.97; N 3.14

Emissionsspektrum: s. Figur 15.

**VI. P∩N* = $Ph_2P$(cyPentMepy), 11: $Cu_2I_2(Ph_2P(cyPentMepy))_3$,12**

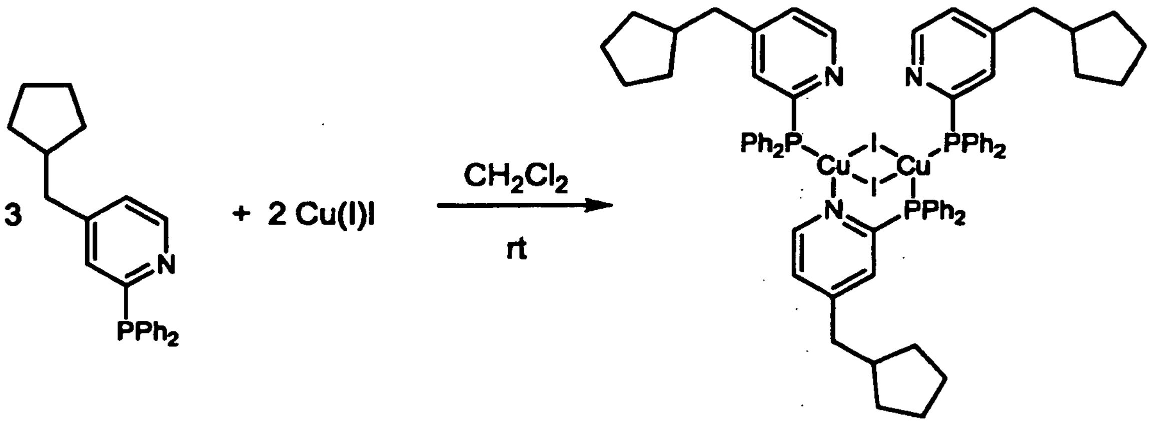


Bei der Verbindung **12** handelt es sich um einen gelben, feinkristallinen Feststoff. Durch Einführung der Cyclopentylmethyleinheit als Substituent der Liganden E∩N* liegt die Löslichkeit bei für die OLED-Bauteilherstellung ausreichenden 30-40 mg Komplex pro mL Dichlorbenzol (ohne Substituent kaum Löslichkeit in Dichlorbenzol).

Charakterisierung:

Elementaranalyse:
gef.: C 58.05; H 5.04; N 2.93

ges.: C 58.48; H 5.12; N 2.97

Emissionsspektrum: s. Figur 16

**VII. P∩N* = $Ph_2P$(heptpy), 13: $Cu_2I_2(Ph_2P(heptpy))_3$, 14**

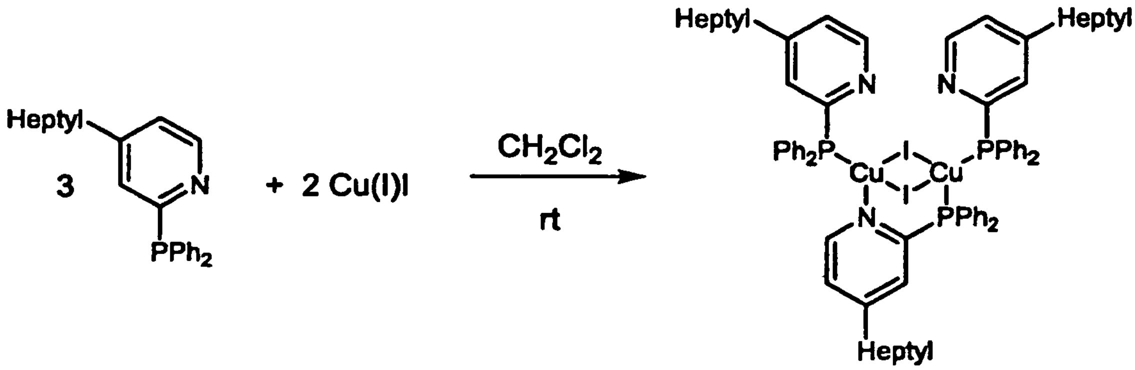


Bei der Verbindung **14** handelt es sich um einen gelben, feinkristallinen Feststoff. Durch Einführung der Heptyleinheit als Substituent der Liganden E∩N* liegt die Löslichkeit bei für die OLED-Bauteilherstellung ausreichenden 35-45 mg Komplex pro mL Dichlorbenzol (ohne Substituent kaum Löslichkeit in Dichlorbenzol).

Charakterisierung:

Elementaranalyse:
gef.: C 58.91; H 5.64; N 2.85
ges.: C 59.02; H 5.78; N 2.87

Emissionsspektrum: s. Figur 17

**VIII. P∩N* = $Ph_2P$(butinpy), 15: $Cu_2I_2(Ph_2P(butinpy))_3$, 16**

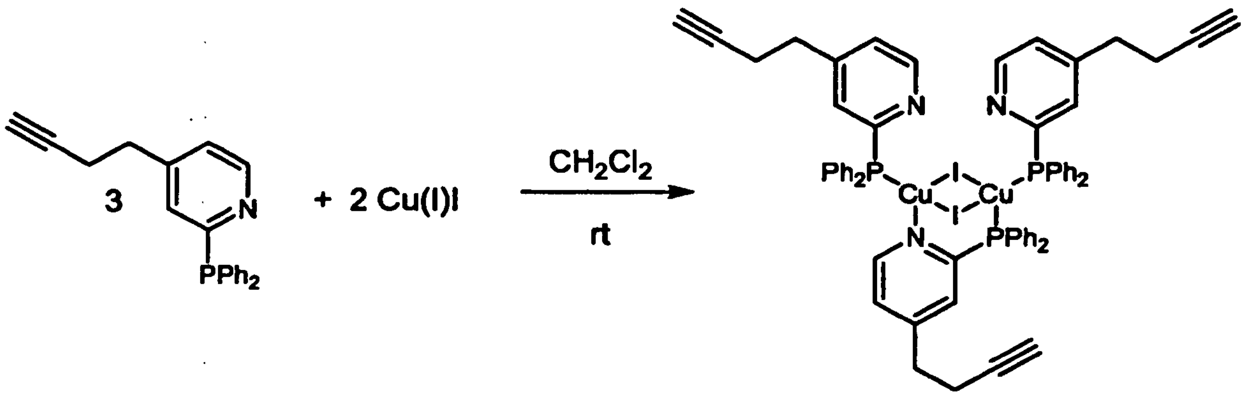


Bei der Verbindung 16 handelt es sich um einen gelben, feinkristallinen Feststoff.

Charakterisierung:

Elementaranalyse:
gef.: C 55.40; H 4.05; N 2.95
(mit einem Molekül $CH_2Cl_2$)
ges.: C 57.02; H 4.10; N 3.17

Emissionsspektrum: s. Figur 18

**IX. P∩N* = $Ph_2P$(4vinylphenpy), 17: $Cu_2I_2(Ph_2P(4vinylphenpy))_3$, 18**

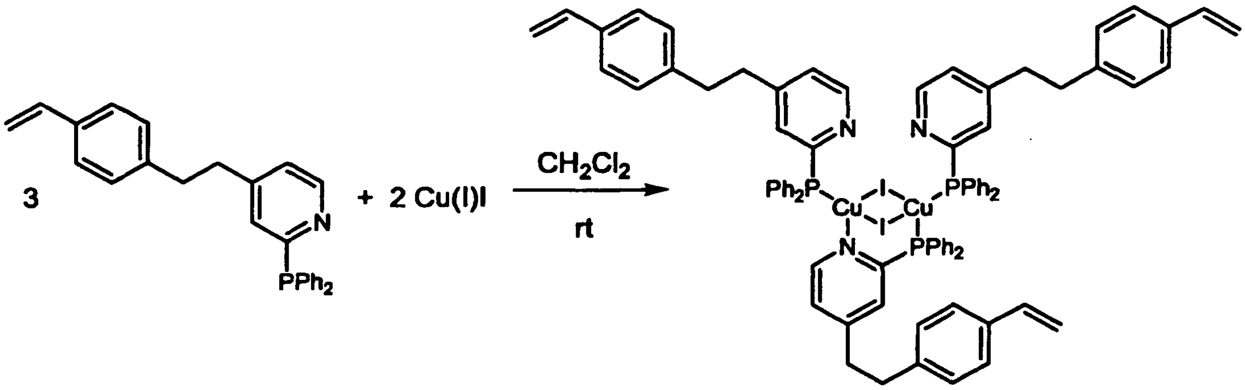


Bei der Verbindung **18** handelt es sich um einen gelben, feinkristallinen Feststoff.

Charakterisierung:

Elementaranalyse:
gef.: C 60.24; H 4.59; N 2.61
(mit einem Molekül $CH_2Cl_2$)
ges.: C 62.31; H 4.65; N 2.69

Emissionsspektrum: s. Figur 19

**X. P∩N* = $Ph_2P$(dmap), 19: $Cu_2I_2(Ph_2P(dmap))_3$, 20**

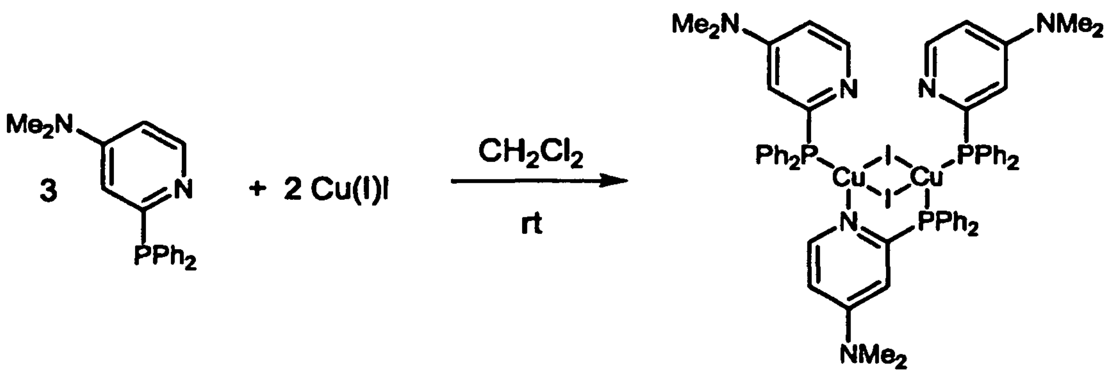


Bei der Verbindung **20** handelt es sich um einen weißen, feinkristallinen Feststoff.

Charakterisierung:

Elementaranalyse:
gef.: C 52.39; H 4.44; N 6.38
ges.: C 52.67; H 4.42; N 6.47

Kristallstruktur: s. Figur 20A
Emissionsspektrum: s. Figur 20B

**XI. P∩N* = $Ph_2P(6Fpy)$, 21: $Cu_2I_2(Ph_2P(6Fpy))_3$, 22**

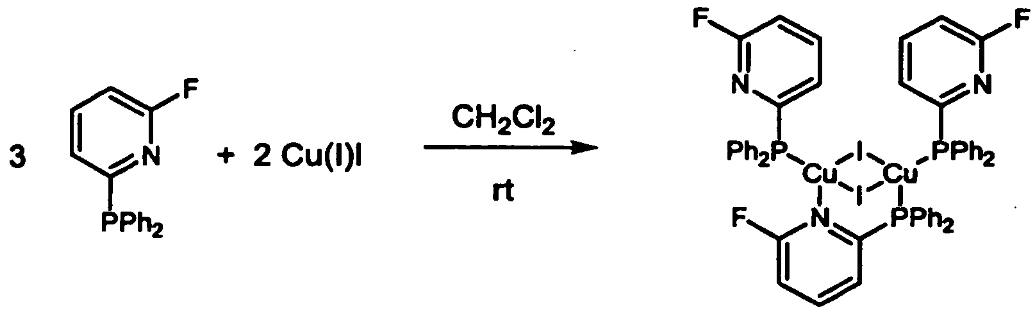


Bei der Verbindung **22** handelt es sich um einen gelben, feinkristallinen Feststoff.

Charakterisierung:

Elementaranalyse:
gef.: C 50.17; H 3.29; N 3.42
ges.: C 50.02; H 3.21; N 3.43

Kristallstruktur: s. Figur 21A
Emissionsspektrum: s. Figur 21B

**XII. P∩N* = $Ph_2P(pyrazin)$, 23: $Cu_2I_2(Ph_2P(pyrazin))_3$, 24**

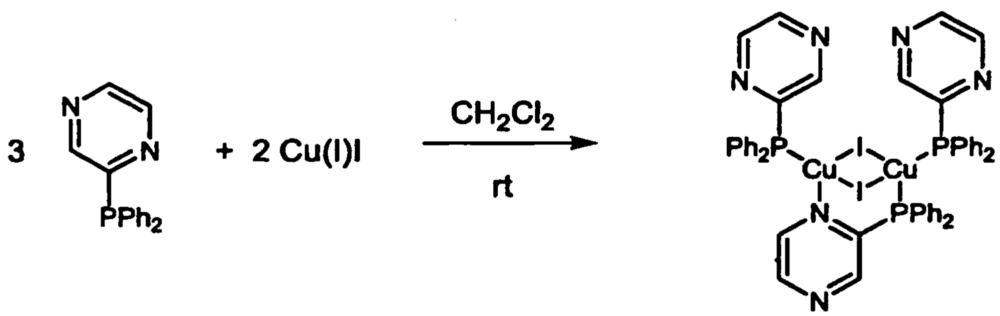


Bei der Verbindung **24** handelt es sich um einen intensiv gelb gefärbten, feinkristallinen Feststoff.

**XIII. P∩N* = $Ph_2P$(6OMepyridazin), 25: $Cu_2I_2(Ph_2P(6OMepyridazin))_3$, 26**

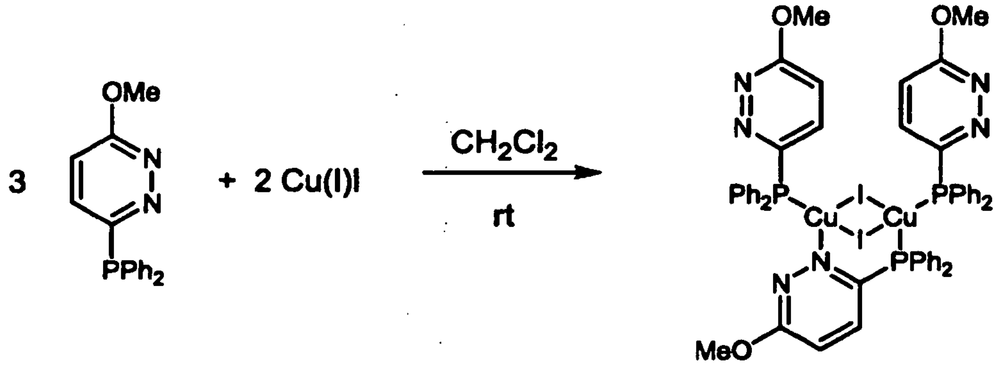


Bei der Verbindung 26 handelt es sich um einen gelborange gefärbten, feinkristallinen Feststoff.

Charakterisierung:

Elementaranalyse:
gef.: C 47.61; H 3.56; N 6.53
ges.: C 48.47; H 3.59; N 6.65

**XIV. PnN* = $Ph_2P$(bnzthia), 27: $Cu_2I_2(Ph_2P(bnzthia))_3$, 28**

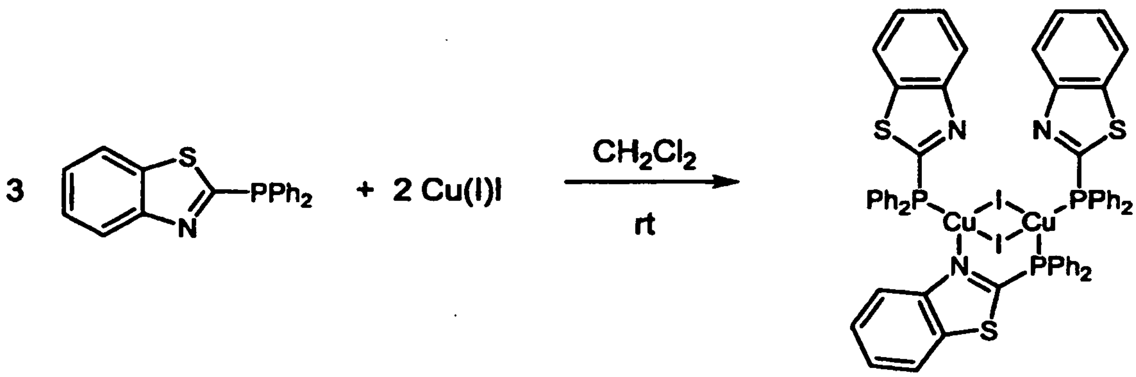


Bei der Verbindung **28** handelt es sich um einen gelben, feinkristallinen Feststoff.

Charakterisierung:

Elementaranalyse:
gef.: C 51.19; H 3.34; N 3.05
ges.:C51.13;H3.16;N3.14

Kristallstruktur: s. Figur 22A
Emissionsspektrum: s. Figur 22B

**XV. P∩N* = $Ph_2P(5Fpy)$, 29: $Cu_2I_2(Ph_2P(5Fpy))_3$, 30**

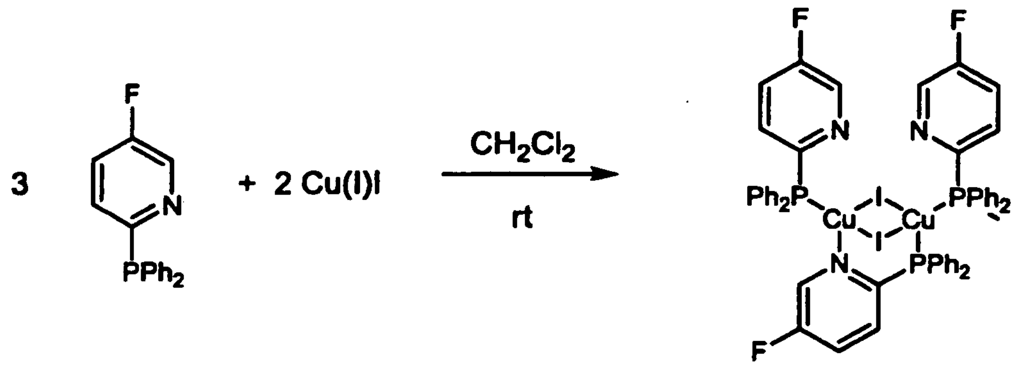


Bei der Verbindung **30** handelt es sich um einen gelben, feinkristallinen Feststoff

Charakterisierung:

Elementaranalyse:
gef.: C 49.37; H 3.18; N 1,76
ges.: C 50.02; H 3.21; N 3.43

Emissionsspektrum: s. Figur 23

**XVI. P∩N* = $Ph_2P(Me_2qn)$, 31: $Cu_2I_2(Ph_2P(Me_2qn))_3$, 32**

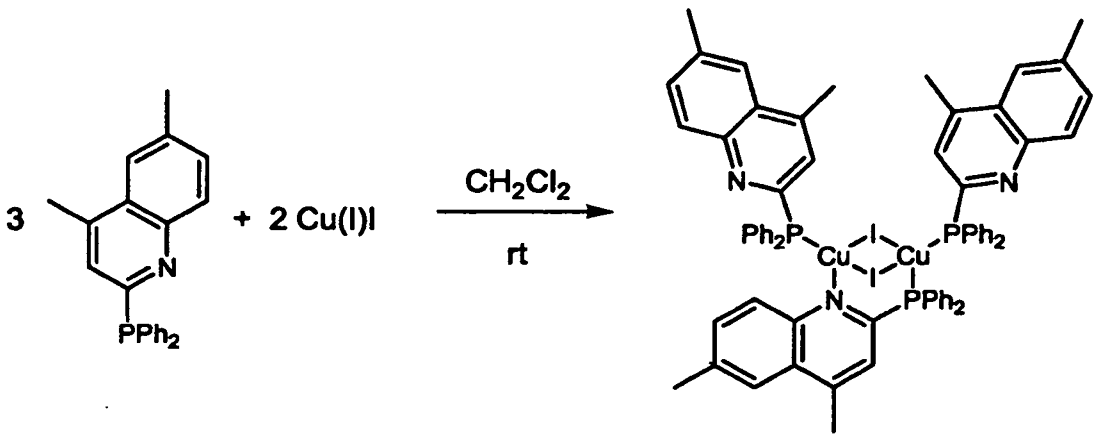


Bei der Verbindung **32** handelt es sich um einen ockerfarbenen, feinkristallinen Feststoff.

Charakterisierung:

Elementaranalyse:
gef.: C 59.52; H 4.78; N 2.73
ges.: C 58.98; H 4.30; N 2.99

Emissionsspektrum: s. Figur 24

**XVII. P∩N* = $Ph_2P$(quinox), 33: $Cu_2I_2(Ph_2P(quinox))_3$, 34**

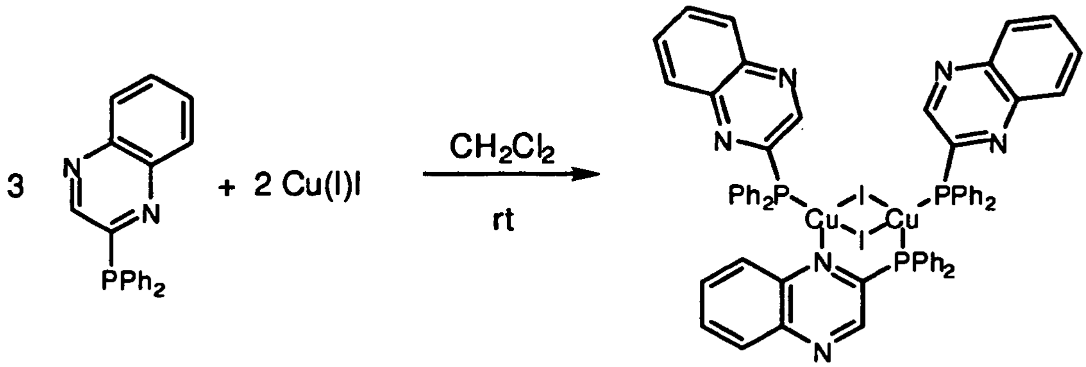


Bei der Verbindung **34** handelt es sich um einen orange gefärbten, feinkristallinen Feststoff.

Charakterisierung:

Elementaranalyse:
gef.: C 51.78; H 3.42; N 5.84
(mit einem Molekül Dichlormethan)
ges.: C 54.43; H 3.43; N 6.35

Emissionsspektrum: s. Figur 25

**Quatenmechanische Berechnungen**

Ausgehend von der Kristallstruktur von **4c** wurden Dichtefunktionaltheorie- (DFT-)Rechnungen auf dem B3LYP/6-31G(d,p)-Niveau durchgeführt. Analog zur Situation bei $[Cu_2X_2(PPh_3)_2nap]$ bestehen im Grundzustand die besetzten Orbitale im Bereich des HOMOs hauptsächlich aus Cu- und Br-Orbitalen, während die unbesetzten Orbitale auf dem π-System v.a. des überbrückenden Liganden zu finden sind (Fig. 12). Als Ursprung der Emission wird anhand dieser Ergebnisse daher ein $\{Cu_2X_2\}\rightarrow\pi^*$(Ligand) charge transfer Zustand angenommen.

**Figuren:**

Es zeigen:

Figur 1: Schematische und vereinfachte Darstellung zur Funktionsweise eines OLEDs (die aufgebrachten Schichten sind z. B. nur ca. 300 nm dick);

Figur 2 : Festkörperstruktur von **2;**

Figur 3: Festkörperstruktur von **3;**

Figur 4: Festkörperstruktur von **4a;**

Figur 5: Festkörperstruktur von **4c;**

Figur 6: Emissionsspektren fester, kristalliner Proben von **4a - 4c** (Anregung bei 380 nm);

Figur 7: Komponente der Festkörperstruktur von **5c;**

Figur 8: Emissionsspektren fester, kristalliner Proben von **5a - 5c** (Anregung bei 380 nm);

Figur 9: Komponente der Festkörperstruktur von **6c;**

Figur 10: Emissionsspektrum einer festen, kristallinen Probe von **6c** (Anregung bei 420 nm);

Figur 11: Emissionsabklingkurve von **6c** bei 300 K, Anregung 420 nm;

Figur 12: Berechnete Grenzorbitale des Grundzustands von **4c;** und

Figur 13: Beispiel für ein OLED-Device mit erfindungsgemäßer Emitterschicht, die nass-chemisch aufgetragen werden soll. Die Schichtdickenangaben gelten als Beispielwerte.

Figur 14: A: Die Kristallstruktur von **8.**
B: Das Emissionsspektrum von **8.** Emissionsspektrum einer festen Probe von **8** (Halogen = I) als Film auf Glassubstrat bei 300K, Anregung bei 355 nm. Emissionsmaximum bei 551 nm.

Figur 15: Emissionsspektrum einer festen Probe von **10** (Halogen = I) als Film auf Glassubstrat bei 300K, Anregung bei 355nm. Emissionsmaximum bei 551 nm

Figur 16: Emissionsspektrum einer festen Probe von **12** (Halogen = I) als Film auf Glassubstrat bei 300 K, Anregung bei 355 nm. Emissionsmaximum bei 551 nm.

Figur 17: Emissionsspektrum einer festen Probe von **14** (Halogen = I) als Film auf Glassubstrat bei 300 K, Anregung bei 355 nm. Emissionsmaximum bei 551 nm.

Figur 18: Emissionsspektrum einer festen Probe von **16** (Halogen = I) als Film auf Glassubstrat bei 300 K, Anregung bei 355 nm. Emissionsmaximum bei 550 nm.

Figur 19: Emissionsspektrum einer festen Probe von **18** (Halogen = I) als Film auf Glassubstrat bei 300 K, Anregung bei 355 nm. Emissionsmaximum bei 552 nm.

Figur 20: A: Kristallstruktur von **20.**
B: Emissionsspektrum einer festen Probe von **20** (Halogen = I) als Film auf Glassubstrat bei 300 K, Anregung bei 355 nm. Emissionsmaximum bei 521 nm.

Figur 21: A: Kristallstruktur von **22.**
B: Emissionsspektrum einer festen Probe von **22** (Halogen = I) als Film auf Glassubstrat bei 300 K, Anregung bei 355 nm. Emissionsmaximum bei 561 nm.

Figur 22: A: Kristallstruktur von **28.**
B: Emissionsspektrum einer festen Probe von **28** (Halogen = I) als Film auf Glassubstrat bei 300 K, Anregung bei 355 nm. Emissionsmaximum bei 574 nm.

Figur 23: Emissionsspektrum einer festen Probe von **30** (Halogen = I) als Film auf Glassubstrat bei 300 K, Anregung bei 355 nm. Emissionsmaximum bei 572 nm.

Figur 24: Emissionsspektrum einer festen Probe von **32** (Halogen = I) als Film auf Glassubstrat bei 300 K, Anregung bei 355 nm. Emissionsmaximum bei 597 nm.

Figur 25: Emissionsspektrum einer festen Probe von **34** (Halogen = I) als Film auf Glassubstrat bei 300 K, Anregung bei 355 nm. Emissionsmaximum bei 679 nm.

Figur 13 zeigt ein Beispiel für ein OLED-Device für die erfindungsgemäße Emitterschicht, die einen erfindungsgemäßen Kupfer(I)komplex aufweist. Zum Beispiel lassen sich in einem typischen OLED-Schichtaufbau, bestehend aus einer ITO-Anode, einem Lochleiter aus PEDOT/PSS, der erfindungsgemäßen Emitterschicht, gegebenenfalls einer Lochblockierschicht, einer Elektronenleiterschicht, einer dünnen LiF- oder CsF-Zwischenschicht zur Verbesserung der Elektroneninjektion sowie einer Metall-Elektrode (Kathode) gute Leistungseffizienzen erzielen. Diese verschiedenen

Schichten mit einer Gesamtdicke von einigen 100 nm lassen sich z. B. auf einem Glassubstrat oder einem sonstigen Trägermaterial aufbringen. Die gezeigten Schichten werden im Folgenden kurz erläutert:

1. Als Trägermaterial kann Glas oder jedes andere geeignete feste oder flexible durchsichtige Material verwendet werden.
2. ITO = Indium-Zinn-Oxid
3. PEDOT/PSS (= Polyethylendioxythiophen/Polystyrolsulfonsäure): Hierbei handelt es sich um ein Lochleitermaterial (HTL = hole transport layer), das wasserlöslich ist.
4. Emitter-Layer, häufig mit EML abgekürzt, mit erfindungsgemäßer Emittersubstanz. Das Matrixmaterial des Emitter-Layers besteht aus gängigen und bekannten hierfür geeigneten Materialien, z. B. PVK (Polyvinylcarbazol) oder CBP (4,4'-Bis(9-carbazolyl)biphenyl). Die Emittersubstanz wird als Suspension mit kleiner Teilchengröße (kleiner 20 bis 30 nm) z. B. durch Spin-Coating aufgebracht.
5. ETL = Elektronentransportmaterial (ETL = electron transport layer). Beispielsweise kann das aufdampfbare $Alq_3$ verwendet werden. Dicke z. B. 40 nm.
6. Die sehr dünne Zwischenschicht aus z. B. CsF oder LiF verringert die Elektroneninjektionsbarriere und schützt die ETL-Schicht. Diese Schicht wird in der Regel aufgedampft. Für einen weiter vereinfachten OLED-Aufbau können gegebenenfalls die ETL- und die CsF-Schicht entfallen.
7. Die leitende Kathodenschicht wird aufgedampft. A1 repräsentiert ein Beispiel. Es können auch Mg:Ag (10:1) oder andere Metalle verwendet werden.

Die am OLED-Device anliegende Spannung beträgt z. B. 3 bis 15 V.

**Referenzen**

[i] C. Adachi, M. A. Baldo, S. R. Forrest, S. Lamansky, M. E. Thompson, R. C. Kwong, Appl. Phys. Lett. 2001, 78, 1622.
[ii] X. H. Yang, D. C. Müller, D. Neher, K. Meerholz, Adv. Mater. 2006, 18, 948; X. H. Yang, D. Neher, Appl. Phys. Lett. 2004, 84, 2476.
[iii] J. Shinar (Hrsg.), Organic light-emitting devices - A survey, AIP-Press, Springer, New York, 2004.
[iv] H. Yersin, Top. Curr. Chem. 2004, 241, 1.
[v] H. Yersin, Highly Efficient OLEDs with Phosphorescent Materials, Wiley-VCH, Weinheim 2008.
[vi] Z. H. Kafafi, Organic Electroluminescence, Taylor & Francis, Boca Raton, 2005.
[vii] M. E. Thompson, P. I. Djurovich, J. Li (University of Southern California, Los Angeles, CA), WO 2004/017043 A2, 2004.
[viii] M. E. Thompson, P. I. Djurovich, R. Kwong (University of Southern California, Los Angeles, CA, Universal Display Corp, Ewing, NY), WO 2004/016711 A1, 2004.
[ix] A. Tsuboyama, S. Okada, T. Takiguchi, K. Ueno, S. Igawa, J. Kamatani, M. Furugori, H. Iwawaki (Canon KK, Tokyo), WO 03/095587 A1, 2003.
[x] C.-M. Che, US 2003/0205707 A1, 2003.
[xi] C.-M. Che, W. Lu, M. C.-W. Chan, US 2002/0179885 A1, 2002.
[xii] J. Kamatani, S. Okada, A. Tsuboyama, T. Takiguchi, S. Igawa, US 2003/186080 A1, 2003.
[xiii] P. Stößel, I. Bach, A. Büsing (Covion Organic Semiconductors GmbH), DE 10350606 A1, 2005.
[xiv] M. Bold, C. Lennartz, M. Egen, H.-W. Schmidt. M. Thelakkat, M. Bäte, C. Neuber, W. Kowalsky, C. Schildknecht (BASF AG), DE 10338550 A1, 2005.
[xv] C. Lennartz, A. Vogler, V. Pawlowski (BASF AG), DE 10358665 A1, 2005.
[xvi] B. Hsieh, T. P. S. Thoms, J. P. Chen (Canon KK, Tokyo), US 2006/989273 B2, 2006.
[xvii]N. Schulte, S. Heun, I. Bach, P. Stoessel, K. Treacher (Covion Organic Semiconductors), WO 2006/003000 A1, 2006.
[xviii] A. Vogler, V. Pawlowski, H.-W. Schmidt, M. Thelakkat (BASF AG), WO 2006/032449 A1, 2006.
[xix] T. K. Hatwar, J. P. Spindler, R. H. Young (Eastman Kodak Co), WO 2006/028546 A1, 2006.
[xx] P. C. Ford, E. Cariati, J. Bourassa, Chem. Rev.1999, 99, 3625.
[xxi] H. Araki, K. Tsuge, Y. Sasaki, S. Ishizaka, N. Kitamura, Inorg. Chem. 2007, 46, 10032.
[xxii] A. Rössler, G. Skillas, S. E. Pratsinis, Chemie in unserer Zeit 2001, 35, 32.
[xxiii] Y. Sun, K. Ye, H. Zhang, J. Zhang, L. Zhao, B. Li, G. Yang, B. Yang, Y. Wang, S.-W. Lai, C.-M. Che, Angew. Chem. 2006,118,5738.
[xxiv] Y. Chen, J. F. Gerald, L. T. Chadderton, L. Chaffron, Appl. Phys. Lett. 1999, 74, 2782.

## Patentansprüche

1. Kupfer(J)komplex der Formel A

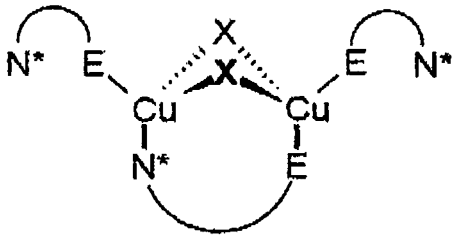

**Formel A**

mit

X = Cl, Br und/oder I
N*∩E = ein zweibindiger Ligand mit

E = Phosphanyl/Arsenyl-Rest der Form $R_2E$ (mit R = Alkyl, Aryl, Alkoxyl, Phenoxyl, oder Amid);
N* = Imin-Funktion, die Bestandteil einer aromatische Gruppe ist, die ausgewählt ist aus Pyridyl, Pyrimidyl, Pyridazinyl, Triazinyl, Oxazolyl, Triazolyl und Imidazolyl,
"∩" = mindestens ein Kohlenstoffatom, das ebenfalls Bestandteil der aromatischen Gruppe ist, wobei sich das Kohlenstoffatom sowohl direkt benachbart zum Imin-Stickstoffatom als auch zum Phosphor- oder Arsenatom befindet,
wobei N*∩E optional mindestens einen Substituenten zur Erhöhung der Löslichkeit des Kupfer(I)komplexes in einem organischen Lösungsmittel aufweist.

2. Kupfer(I)komplex nach Anspruch 1, wobei N*∩E ausgewählt ist aus der Gruppe bestehend aus

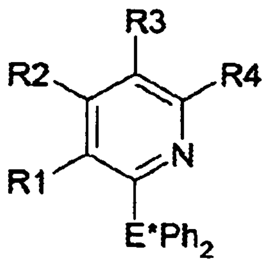 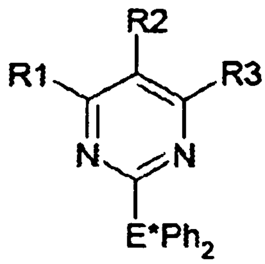 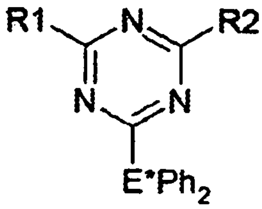 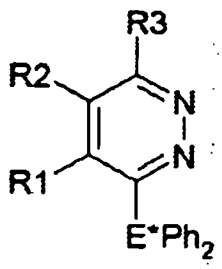

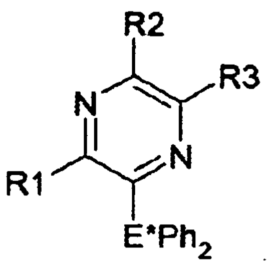 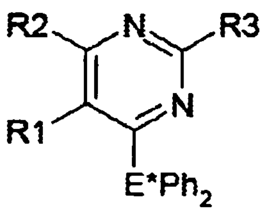 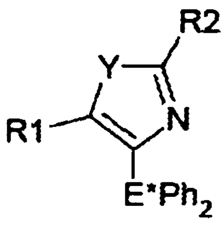 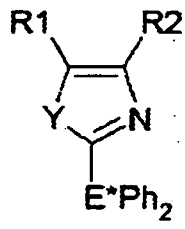

mit

Y = O, S oder NR5
E* = As oder P
R1-R5 = jeweils unabhängig voneinander Wasserstoff, Halogen oder Substituenten, die über Sauerstoff oder Stickstoff gebunden sind, oder Alkyl-, Aryl-, Heteroaryl-, Alkenyl-, Alkinyl, Trialkylsilyl- und Triarylsilyl-Gruppen

oder
Alkyl-, Aryl-, Heteroaryl- und Alkenyl-Gruppen, substituiert mit Halogenen und/oder niedrigen Alkylgruppen wie Methyl-, Butyl- oder Propylgruppen,
wobei die Gruppen R1-R5 optional zu anellierten Ringsystemen führen.

**3.** Kupfer(I)komplex nach Anspruch 1 oder 2, wobei der Substituent zur Erhöhung der Löslichkeit ausgewählt ist aus der Gruppe bestehend aus:

- verzweigten oder unverzweigten oder zyklischen langkettigen Alkylketten einer Länge von C1 bis C30,
- verzweigten oder unverzweigten oder zyklischen langkettigen Alkoxyketten einer Länge von C1 bis C30, verzweigten oder unverzweigten oder zyklischen langkettigen Perfluoralkylketten einer Länge von C1 bis C30, und
- kurzkettigen Polyethern mit einer Kettenlänge von 3-50 Wiederholungseinheiten.

**4.** Verfahren zur Herstellung eines Kupfer(I)komplexes nach Anspruch 1 bis 3, aufweisend den folgenden Schritt:

Durchführen einer Reaktion von N*∩E mit Cu(I)X,
wobei
X = Cl, Br oder I (unabhängig voneinander)
N*∩E = ein zweibindiger Ligand mit
E = Phosphanyl/Arsenyl-Rest der Form $R_2E$ (mit R = Alkyl, Aryl, Alkoxyl, Phenoxyl, oder Amid);
N* = Imin-Funktion, die Bestandteil einer aromatische Gruppe ist, die ausgewählt ist aus Pyridyl, Pyrimidyl, Pyridazinyl, Triazinyl, Oxazolyl, Thiazolyl und Imidazolyl,
"∩" = mindestens ein Kohlenstoffatom, das ebenfalls Bestandteil der aromatischen Gruppe ist, wobei sich das Kohlenstoffatom sowohl direkt benachbart zum Imin-Stickstoffatom als auch zum Phosphor- oder Arsenatom befindet.

**5.** Verfahren nach Anspruch 4, wobei die Reaktion in Dichlormethan durchgeführt wird.

**6.** Verfahren nach Anspruch 4 oder 5, weiterhin aufweisend den Schritt der Zugabe von Diethylether oder Pentan zur Gewinnung des Kupfer(I)komplexes in Form eines Feststoffs.

**7.** Verfahren nach Anspruch 4 bis 6, weiterhin aufweisend den Schritt der Substitution mindestens eines Liganden N*∩E mit mindestens einem Substituenten, der ausgewählt sein kann aus der Gruppe bestehend aus:

- langkettigen, verzweigten oder unverzweigten oder zyklischen Alkylketten einer Länge von C1 bis C30,
- langkettigen, verzweigten oder unverzweigten oder zyklischen Alkoxyketten einer Länge von C1 bis C30,
- verzweigten oder unverzweigten oder zyklischen Perfluoralkylketten einer Länge von C1 bis C30, und
- kurzkettigen Polyethern.

**8.** Verwendung eines Kupfer(I)komplexes nach Anspruch 1 bis 3 als Emitter oder Absorber in einem optoelektronischen Bauelement.

**9.** Verwendung nach Anspruch 8, wobei das optoelektronische Bauelement ausgewählt ist aus der Gruppe bestehend aus:

- Organischen Licht-emittierenden Bauteilen (OLEDs),
- Licht-emittierenden elektrochemischen Zellen,
- OLED-Sensoren, insbesondere in nicht hermetisch nach außen abgeschirmten Gas- und Dampf-Sensoren,
- organischen Solarzellen,
- Organischen Feldeffekttransistoren,
- Organischen Lasern und
- Down-Konversions-Elementen.

**10.** Verwendung nach Anspruch 8 bis 9, **dadurch gekennzeichnet, dass** die Konzentration des Kupfer(I)komplexes als Emitter in optischen Licht emittierenden Bauelementen, insbesondere in OLEDs, zwischen 1 % und 10 % beträgt.

**11.** Optoelektronisches Bauelement, aufweisend einen Kupfer(I)komplex nach Anspruch 1 bis 3.

**12.** Optoelektronisches Bauelement nach Anspruch 11, ausgeformt als ein Bauelement ausgewählt aus der Gruppe bestehend aus organischem lichtemittierendem Bauelement, organischer Diode, organischer Solarzelle, organischem Transistor, organischer lichtemittierender Diode, Licht-emittierender elektrochemischer Zelle, organischem Feldeffekttransistor und organischem Laser.

**13.** Verfahren zur Herstellung eines optoelektronischen Bauelements, wobei ein Kupfer(I)komplex nach Anspruch 1 bis 3 verwendet wird.

**14.** Verfahren nach Anspruch 13, **gekennzeichnet durch**
Aufbringen eines Kupfer(I)komplexes nach Anspruch 1 bis 3 auf einen Träger, wo das Aufbringen bevorzugt nasschemisch, mittels kolloidaler Suspension oder mittels Sublimation erfolgt.

**15.** Verfahren zur Veränderung der Emissions- und/oder Absorptionseigenschaften eines elektronischen Bauelements, **gekennzeichnet durch**
Einbringen eines Kupfer(I)komplexes nach Anspruch 1 bis 3 in ein Matrixmaterial zur Leitung von Elektronen oder Löchern in einem optoelektronischen Bauelement.

**16.** Verwendung eines Kupfer(I)komplexes nach Anspruch 1 bis 3, insbesondere in einem optoelektronischen Bauelement, zur Umwandlung von UV-Strahlung oder von blauem Licht in sichtbares Licht, insbesondere in grünes, gelbes oder rotes Licht (Down-Konversion).

## Claims

**1.** A copper(I) complex of the formula A

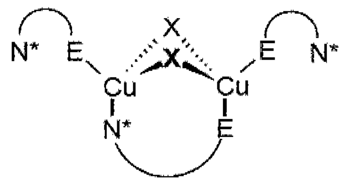

**formula A**

where

X = Cl, Br and/or I
N*∩E = a bidentate ligand where

E = phosphinyl/arsenyl radical of the $R_2E$ form (where R = alkyl, aryl, alkoxy, phenoxy or amide);
N* = imine function which is part of an aromatic group selected from pyridyl, pyrimidyl, pyridazinyl, triazinyl, oxazolyl, thiazolyl and imidazolyl,
"∩" = at least one carbon atom which is likewise part of the aromatic group, where the carbon atom is directly adjacent both to the imine nitrogen atom and to the phosphorus or arsenic atom,
where N*∩E optionally has at least one substituent to increase the solubility of the copper(I) complex in an organic solvent.

**2.** The copper(I) complex of claim 1, wherein N*∩E is selected from the group consisting of

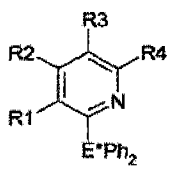 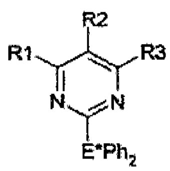 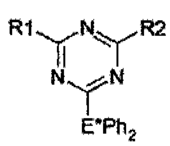 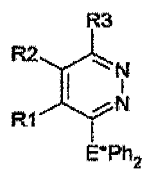

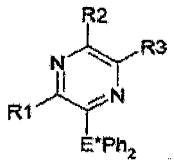
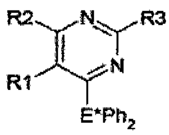
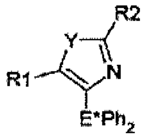
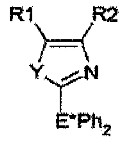

where

Y=O, S or NR5
E* = As or P
R1-R5 = each independently hydrogen, halogen or substituents bonded via oxygen or nitrogen, or alkyl, aryl, heteroaryl, alkenyl, alkynyl, trialkylsilyl and triarylsilyl groups or alkyl, aryl, heteroaryl and alkenyl groups substituted by halogens and/or lower alkyl groups such as methyl, butyl or propyl groups,
where the R1-R5 groups optionally lead to fused ring systems.

**3.** The copper(I) complex of claim 1 or 2, wherein the substituent for increasing the solubility is selected from the group consisting of:

- branched or unbranched or cyclic long alkyl chains of length C1 to C30,
- branched or unbranched or cyclic long alkoxy chains of length C1 to C30,
- branched or unbranched or cyclic long perfluoroalkyl chains of length C1 to C30, and
- short-chain polyethers with a chain length of 3-50 repeat units.

**4.** A process for preparing a copper(I) complex of claims 1 to 3, comprising the following step:

performance of a reaction of N*∩E with Cu(I)X,
where
X (independently) Cl, Br or I
N*∩E = a bidentate ligand where
E = phosphinyl/arsenyl radical of the form $R_2E$ (where R = alkyl, aryl, alkoxyl, phenoxy or amide);
N* = imine function which is part of an aromatic group selected from pyridyl, pyrimidyl, pyridazinyl, triazinyl, oxazolyl, thiazolyl and imidazolyl,
"∩" = at least one carbon atom which is likewise part of the aromatic group, where the carbon atom is directly adjacent both to the imine nitrogen atom and to the phosphorus or arsenic atom.

**5.** The process of claim 4, wherein the redaction is performed in dichloromethane.

**6.** The process of claim 4 or 5, further comprising the step of addition of diethyl ether or pentane to obtain the copper (I) complex in the form of a solid.

**7.** The process of claims 4 to 6, further comprising the step of substitution of at least one ligand N*∩E by at least one substituent which may be selected from the group consisting of:

- long-chain, branched or unbranched or cyclic alkyl chains of length C1 to C30,
- long-chain, branched or unbranched or cyclic alkoxy chains of length C1 to C30,
- branched or unbranched or cyclic perfluoroalkyl chains of length C1 to C30, and
- short-chain polyethers.

**8.** The use of a copper(I) complex of claims 1 to 3 as an emitter or absorbed in an optoelectronic component.

**9.** The use of claim 8, wherein the optoelectronic component is selected from the group consisting of:

- organic light-emitting diodes (OLEDs),
- light-emitting electrochemical cells,
- OLED sensors, especially in gas and vapor sensors without hermetic shielding on the outside,
- organic solar cells,

- organic field-effect transistors,
- organic lasers and
- down-conversion elements.

**10.** The use of claims 8 to 9, **characterized in that** the concentration of the copper(I) complex as an emitter in optical light-emitting components, especially in OLEDs, is between 1% and 10%.

**11.** An optoelectronic component comprising a copper(I) complex of claims 1 to 3.

**12.** The optoelectronic component of claim 11, in the form of a component selected from the group consisting of organic light-emitting component, organic diode, organic solar cell, organic transistor, organic light-emitting diode, light-emitting electrochemical cell, organic field-effect transistor and organic laser.

**13.** A process for producing an optoelectronic component, wherein a copper(I) of claims 1 to 3 is used.

**14.** The process of claim 13, **characterized by**
application of a copper(I) complex of claims 1 to 3 onto a carrier where the application is effected preferably by wet-chemical means, by means of colloidal suspension or by means of sublimation.

**15.** A process for altering the emission and/or absorption properties of an electronic component, **characterized by** introduction of a copper(I) complex of claims 1 to 3 into a matrix material for conduction of electrons or holes in an optoelectronic component.

**16.** The use of a copper(I) complex of claims I to 3, especially in an optoelectronic component, for conversion ofUV radiation or of blue light to visible light, especially to green, yellow or red light (down-conversion).

**Revendications**

**1.** Complexe de cuivre(I) de formule A

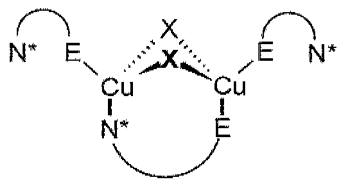

formule A

où

X = cl, Br et/ou I
N*∩E = un ligand à deux liaisons où

E = un radical phosphanyle/arsényle de formule $R_2E$ (où R = alkyle, aryle, alcoxy, phénoxy ou amide) ;
N* = une fonction imine qui fait partie d'un groupe aromatique qui est choisi parmi les groupes pyridyle, pyrimidyle, pyridazinyle, triazinyle, oxazolyle, thiazolyle et imidazolyle,
« n » = au moins un atome de carbone, qui fait également partie du groupe aromatique, l'atome de carbone se trouvant directement adjacent aussi bien à l'atome d'azote en fonction imine qu'à l'atome de phosphore ou d'arsenic,
N*∩E comportant en option au moins un substituant destiné à augmenter la solubilité du complexe de cuivre(I) dans un solvant organique.

**2.** Complexe de cuivre(I) selon la revendication 1, dans lequel N*∩E est choisi dans le groupe constitué par

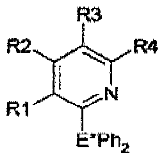
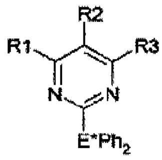
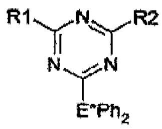
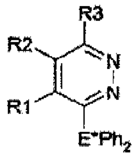

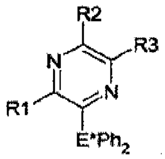
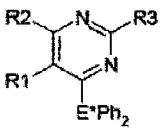
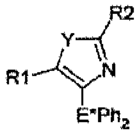
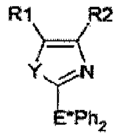

où

Y = O, S ou NR5
E* = As ou P
R1-R5 chacun indépendamment les uns des autres un atome d'hydrogène ou d'halogène ou des substituants qui sont liés par un atome d'oxygène ou d'azote, ou des groupes alkyle, aryle, hétéroaryle, alcényle, alcynyle, trialkylsilyle et triarylsilyle ou
des groupes alkyle, aryle, hétéroaryle et alcényle, substitués par des atomes d' halogène et/ou des groupes alkyle inférieur tels que les groupes méthyle, butyle ou propyle,
les groupes R1-R5 conduisant en option à des systèmes cycliques condensés.

**3.** Complexe de cuivre (I) selon la revendication 1 ou 2, dans lequel le substituant destiné à augmenter la solubilité est choisi dans le groupe constitué pat:

- des chaînes alkyle à longue chaîne ramifiées ou non ramifiées ou cycliques ayant une longueur de C1 à C30,
- des chaînes alcoxy à longue chaîne ramifiées ou non ramifiées ou cycliques ayant une longueur de Cl à C30,
- des chaînes perfluoroalkyle à longue chaîne ramifiées ou non ramifiées ou cycliques ayant une longueur de C1 à C30, et
- des polyéthers à courbe chaîne ayant une longueur de chaîne de 3-50 motifs répétitifs.

**4.** Procédé pour la préparation d'un complexe de cuivre(I) selon l'une quelconque des revendications 1 à 3, comportant l'étape suivante :

exécution d'une réaction de N*∩E avec Cu(I)X,
où
X = Cl, Br ou I (chaque fois indépendamment)
N*∩E = un ligand à deux liaisons où
E = un radical phosphanyle/arsényle de forme $R_2E$ (où R = alkyle, aryle, alcoxy, phénoxy ou amide) ;
N* = une fonction imine qui fait partie d'un groupe aromatique qui est choisi parmi les groupes pyridyle, pyrimidyle, pyridazinyle, triazinyle, oxazolyle, thiazolyle et imidazolyle,
« ∩ » = au moins un atome de carbone, qui fait également partie du groupe aromatique, l'atome de carbone se trouvant directement adjacent aussi bien à l'atome d' azote en fonction imine qu' à l'atome de phosphore ou d'arsenic.

**5.** Procédé selon la revendication 4, dans lequel la réaction est effectuée dans du dichlorométhane.

**6.** Procédé selon la revendication 4 ou 5, comportant en outre l'étape d'addition d'oxyde d'éthyle ou de pentane pour l'obtention du complexe de cuivre (I) sous forme d'un matière solide.

**7.** Procédé selon l'une quelconque des revendications 4 à 6, comportant en outre l'étape de substitution d'au moins un ligand N*∩E par au moins un substituant qui est choisi dans le groupe constitué par :

- des chaînes alkyle à longue chaîne ramifiées ou non ramifiées ou cycliques ayant une longueur de C1 à C30,
- des chaînes alcoxy à longue chaîne ramifiées ou non ramifiées ou cycliques ayant une longueur de C1 à C30,

- des chaînes perfluoroalkyle ramifiées ou non ramifiées ou cycliques ayant une longueur de C1 à C30, et
- des polyéthers à courte chaîne.

8. Utilisation d'un complexe de cuivre(I) selon l'une quelconque des revendications 1 à 3, en tant qu'émetteur ou absorber dans un composant optoélectronique.

9. Utilisation selon la revendication 8, dans laquelle le composant optoélectronique est choisi dans le groupe constitué par :

- des composants photoémetteurs organiques (OLED),
- des cellules électrochimiques photoémettrices,
- des capteurs OLED, en particulier dans des capteurs de gaz et de vapeur non hermétiquement isolés de l'extérieur,
- des cellules solaires organiques,
- des transistors à effet de champ organiques,
- des lasers organiques et
- des éléments de down-conversion.

10. Utilisation selon la revendication 8 et 9, **caractérisée par** ce que la concentration du complexe de cuivre(I) en tant qu'émetteur dans des composants photoémetteurs optiques, en particulier dans des OLED, est comprise entre 1 % et 10 %.

11. Composant optoélectronique, comportant un complexe de cuivre(I) selon l'une quelconque des revendications 1 à 3.

12. Composant optoélectronique selon la revendication 11, conçu en tant qu'un composant choisi dans le groupe constitué par un composant photoémetteur organique, une diode organique, une cellule solaire organique, un transistor organique, une diode photoémettrice organique, une cellule électrochimique photoémettrice, un transistor à effet de champ organique et un lasser organique.

13. Procédé pour la fabrication d'un composant optoélectronique, dans lequel on utilise un complexe de cuivre(T) selon l'une quelconque des revendications 1 à 3.

14. Procédé selon la revendication 13, **caractérisé par**
l'application d'un complexe de cuivre(I) selon l'une quelconque des revendications 1 à 3 sur un support, où l'application s'effectue de préférence par voie chimique-humide, au moyen d'une suspension colloïdale ou par sublimation.

15. Procédé pour la modification des propriétés d'émission ou d'absorption d'un composant électronique, **caractérisé par**
l'introduction d'un complexe de cuivre (I) selon l'une quelconque des revendications 1 à 3 dans un matériau matrice pour la conduction d'électrons ou de trous dans un composant optoélectronique.

16. Utilisation d'un complexe de cuivre(I) selon l'une quelconque des revendications 1 à 3, en particulier dans un composant optoélectronique, pour la conversion d'un rayonnement UV ou de lumière bleue en lumière visible, en particulier en lumière verte, jaune ou rouge (down-conversion).

**Fig. 1**

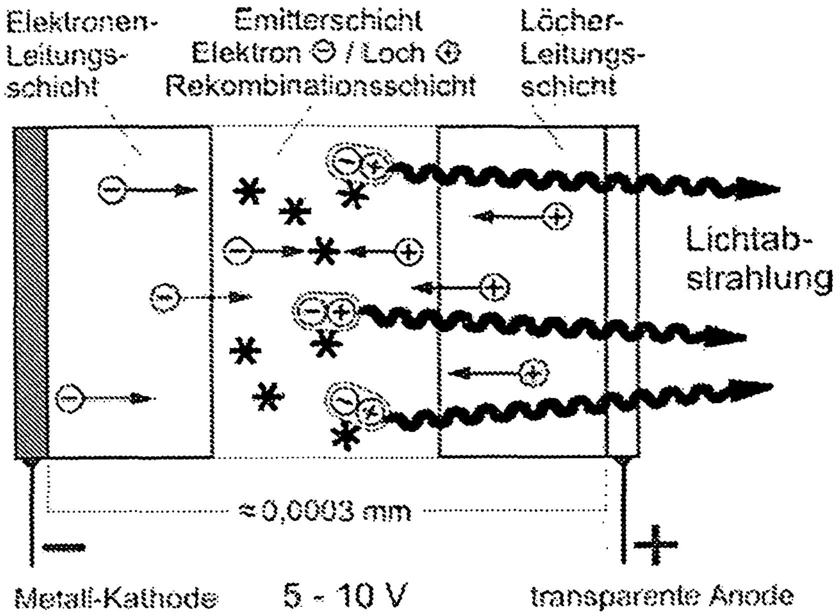
Elektronen-
Leitungs-
schicht
Emitterschicht
Elektron ⊖ / Loch ⊕
Rekombinationsschicht
Löcher-
Leitungs-
schicht
Lichtab-
strahlung
≈ 0,0003 mm
−
+
Metall-Kathode
5 - 10 V
transparente Anode

**Fig. 2**

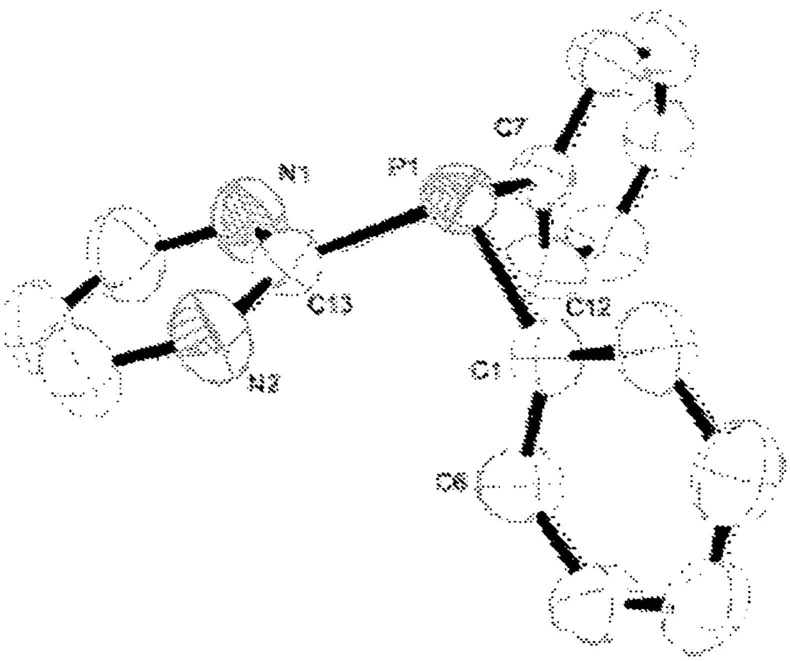

**Fig. 3**

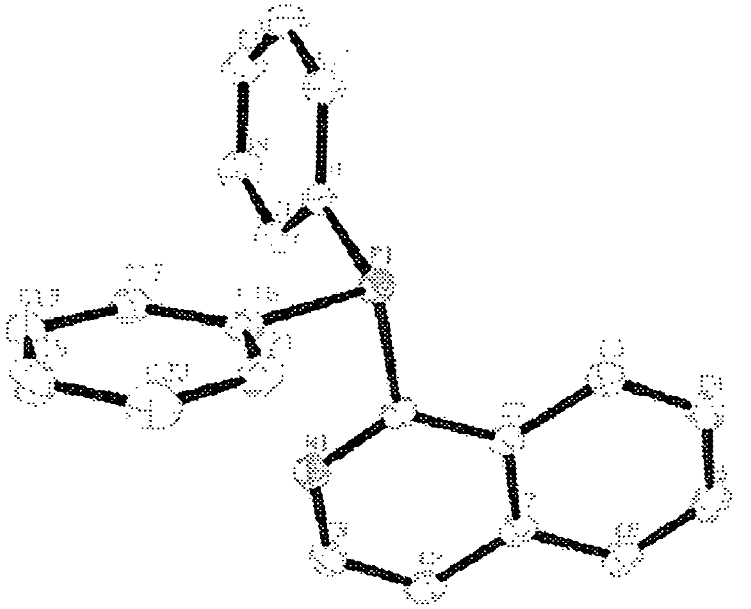

**Fig. 4**

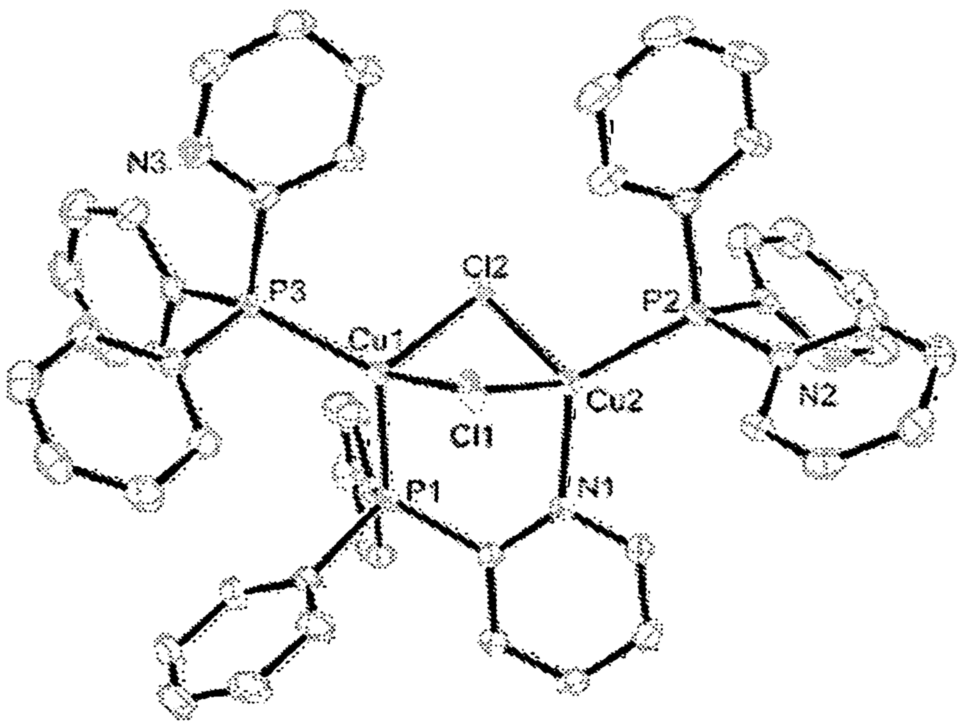

Fig. 5

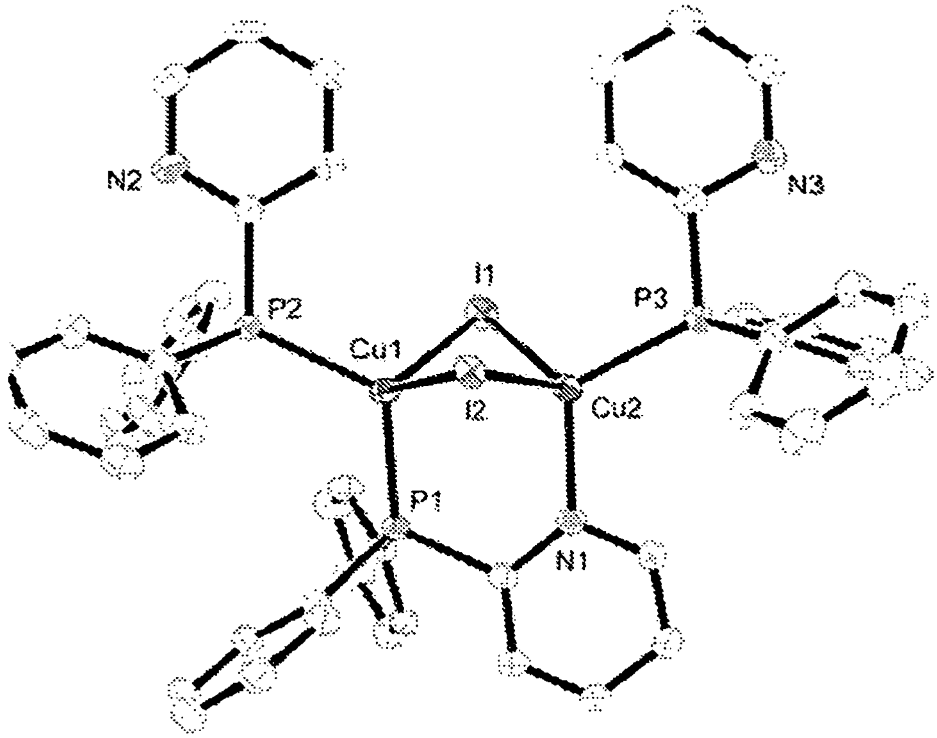

Fig. 6

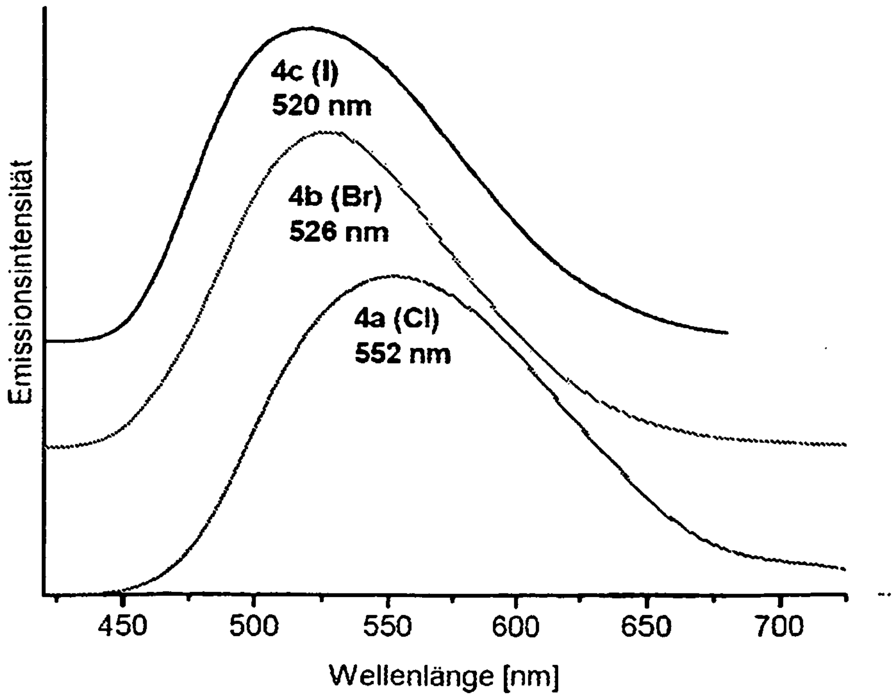
4c (I)
520 nm
4b (Br)
526 nm
4a (Cl)
552 nm
Emissionsintensität
450
500
550
600
650
700
Wellenlänge [nm]

Fig. 7

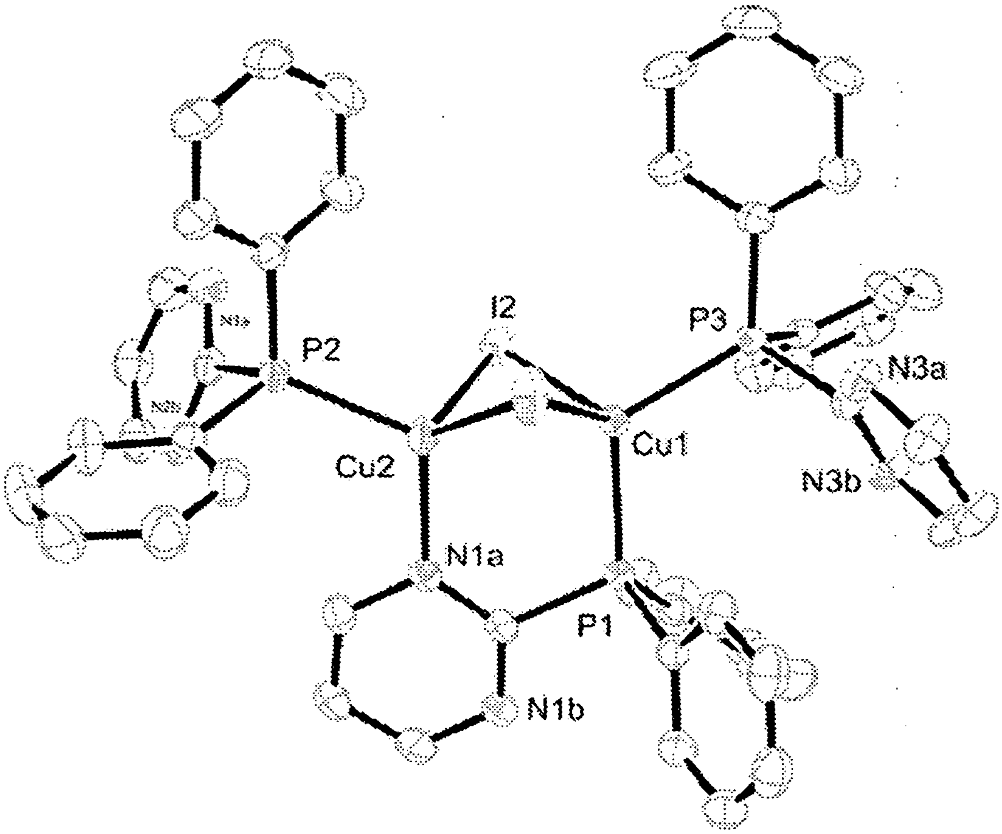

Fig. 8

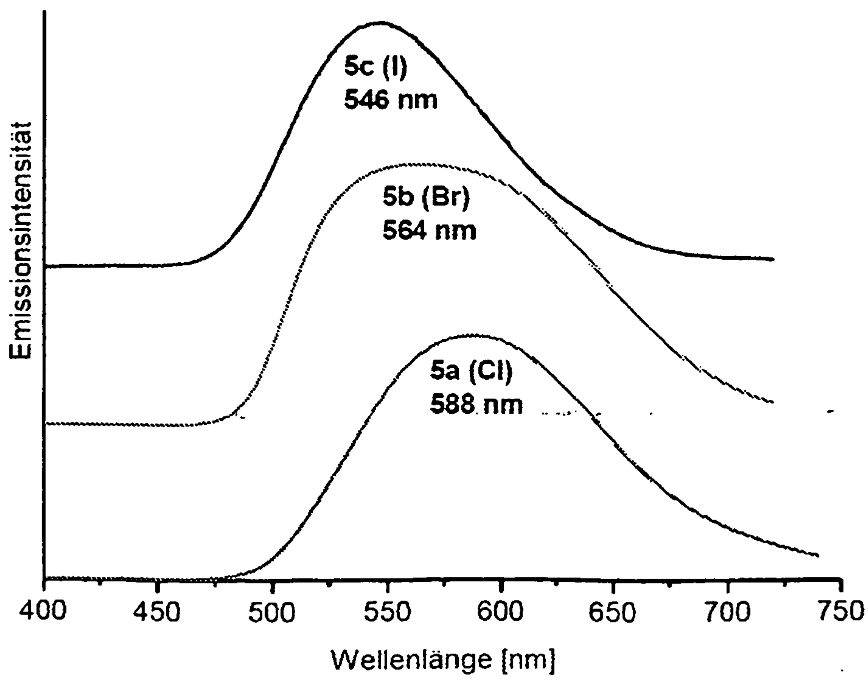
Emissionsintensität
5c (I)
546 nm
5b (Br)
564 nm
5a (Cl)
588 nm
400
450
500
550
600
650
700
750
Wellenlänge [nm]

Fig. 9

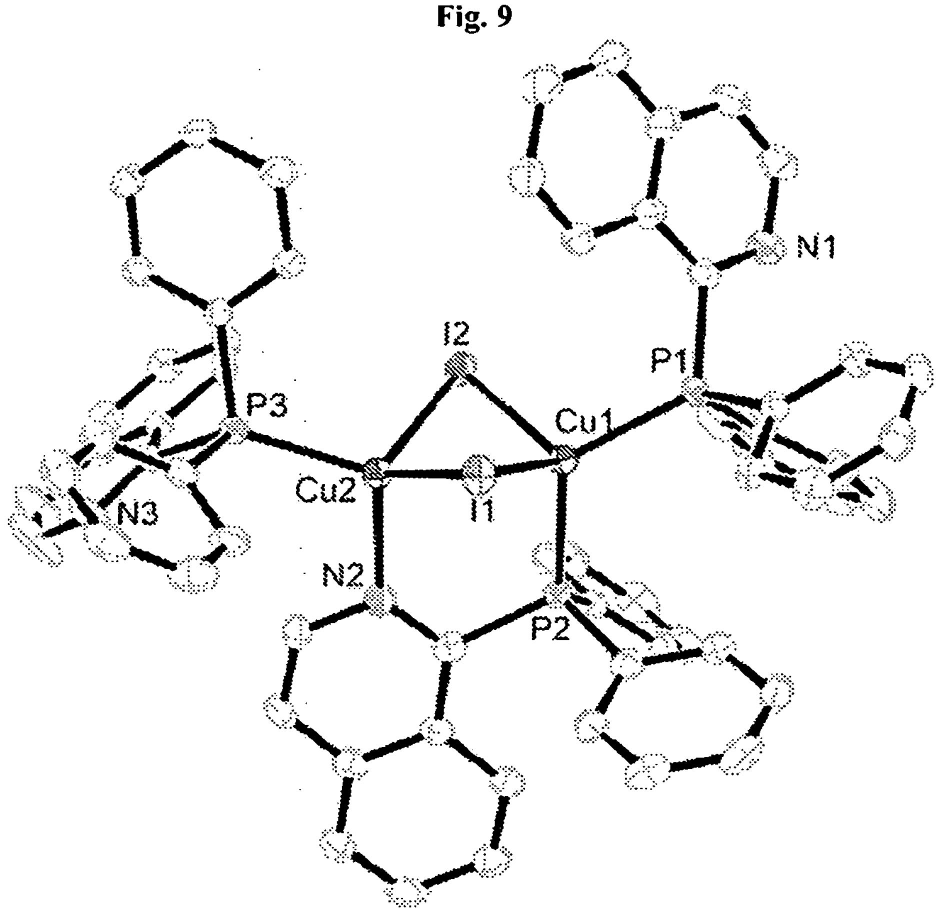

Fig. 10

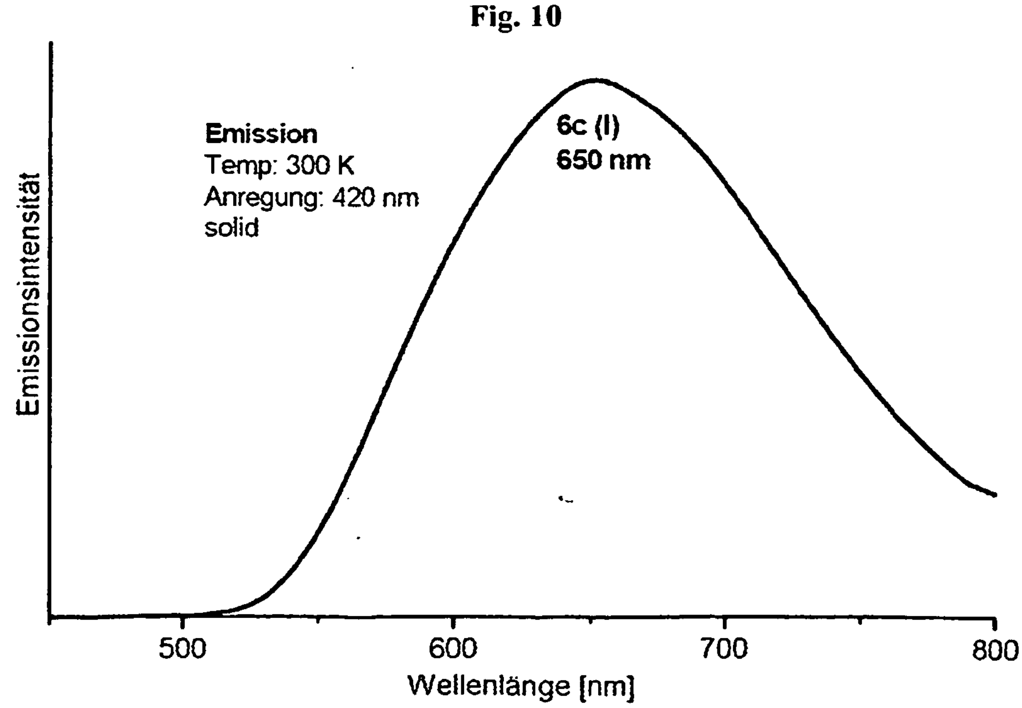
Emission
Temp: 300 K
Anregung: 420 nm
solid
6c (I)
650 nm
Emissionsintensität
500
600
700
800
Wellenlänge [nm]

Fig. 11

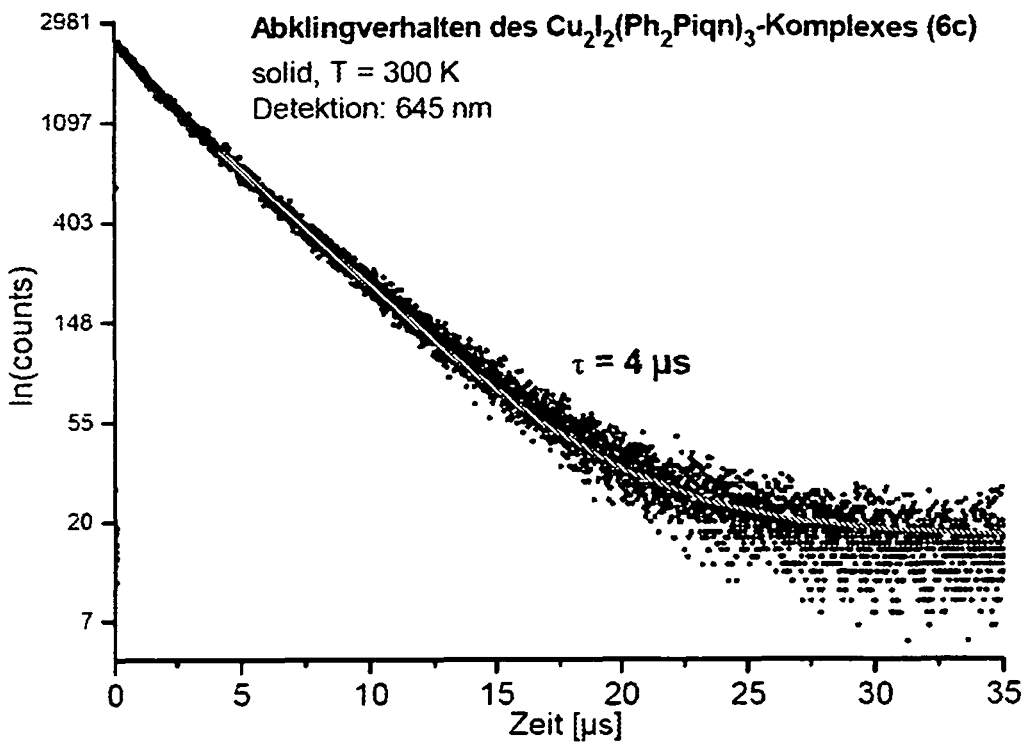
Abklingverhalten des $Cu_2I_2(Ph_2Piqn)_3$-Komplexes (6c)
solid, T = 300 K
Detektion: 645 nm
τ = 4 µs
ln(counts)
2981
1097
403
148
55
20
7
0
5
10
15
20
25
30
35
Zeit [µs]

Fig. 12

Besetzte Orbitale Unbesetzte Orbitale

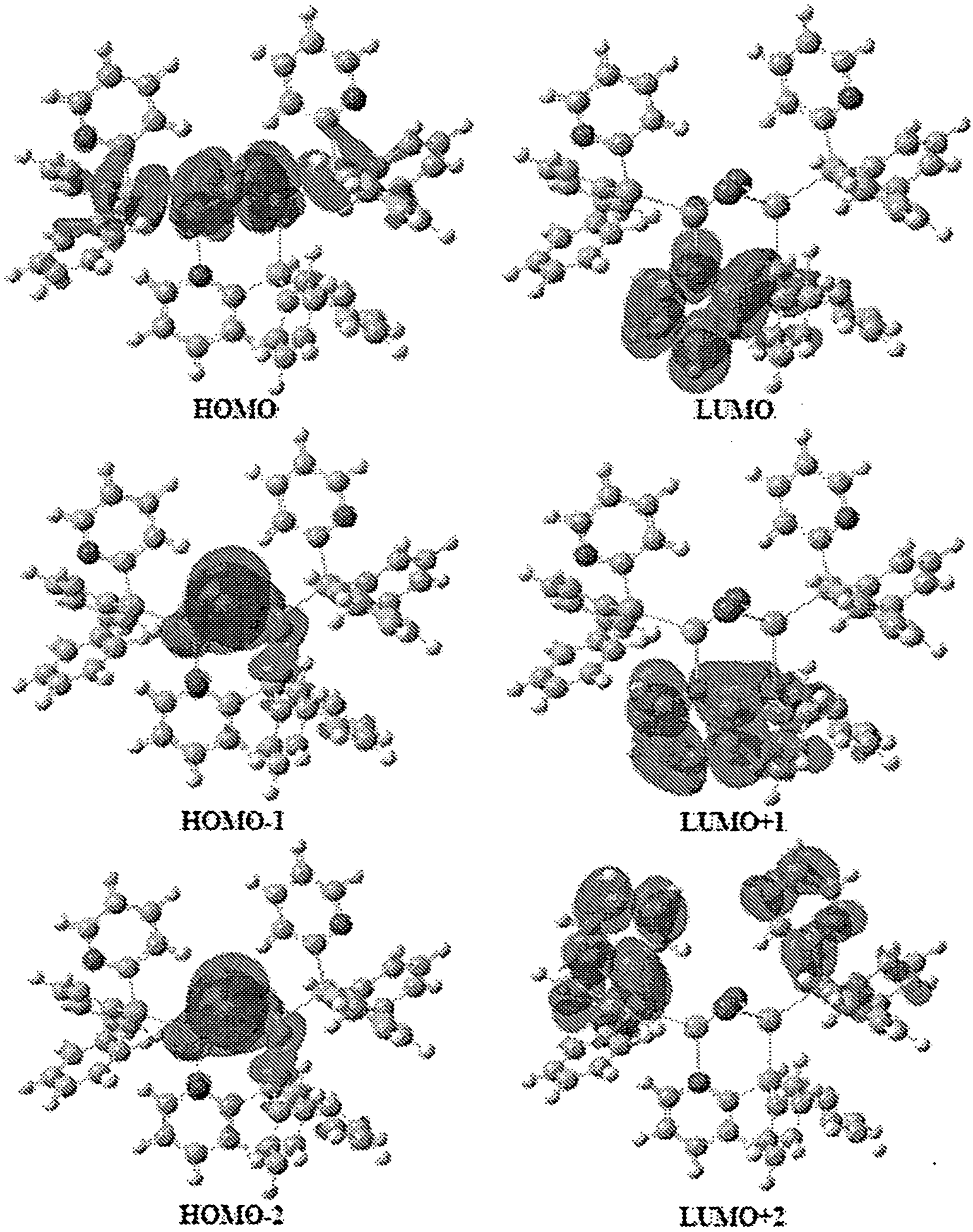

Fig. 13

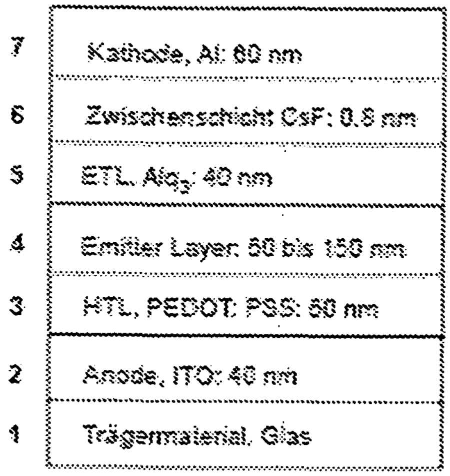


Fig. 14 A

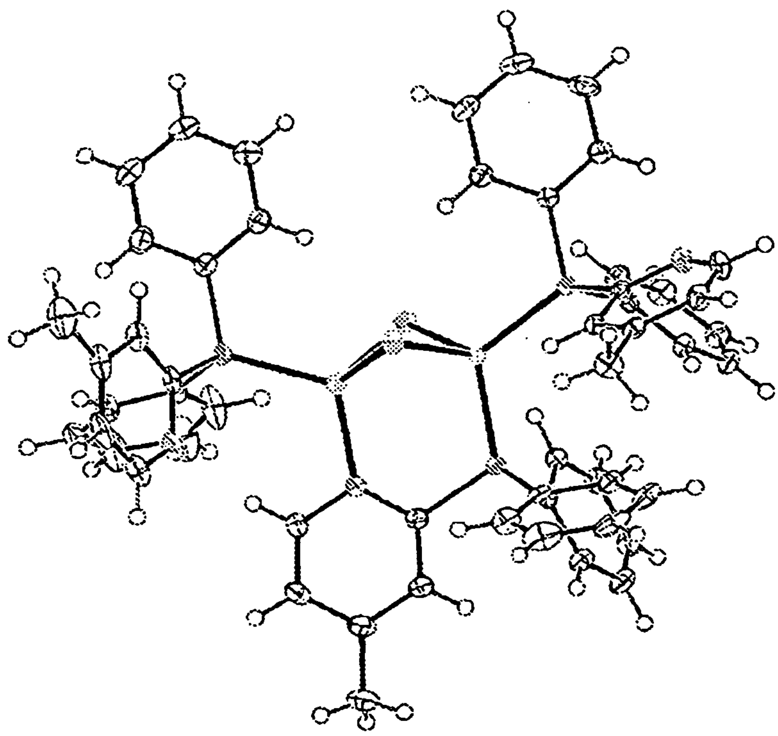

Fig. 14 B

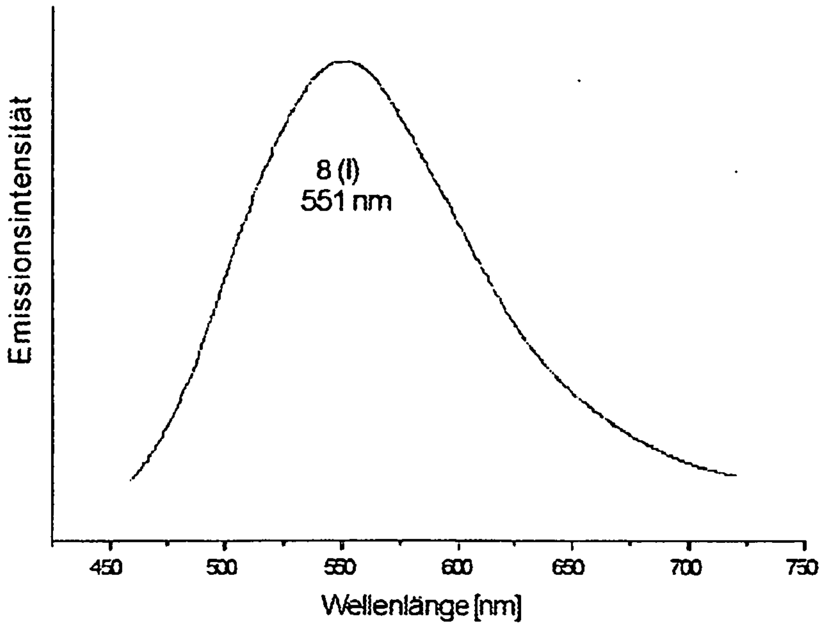


Fig. 15

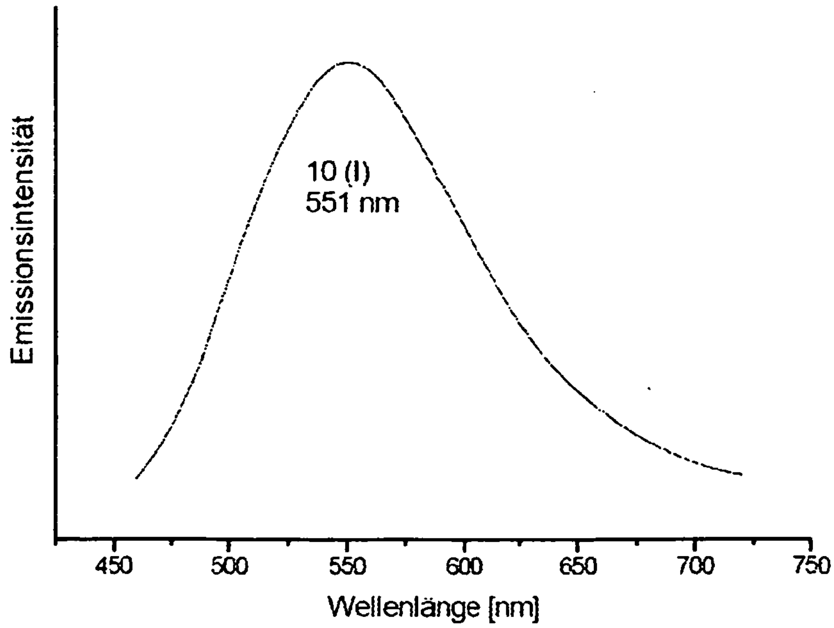

Fig. 16

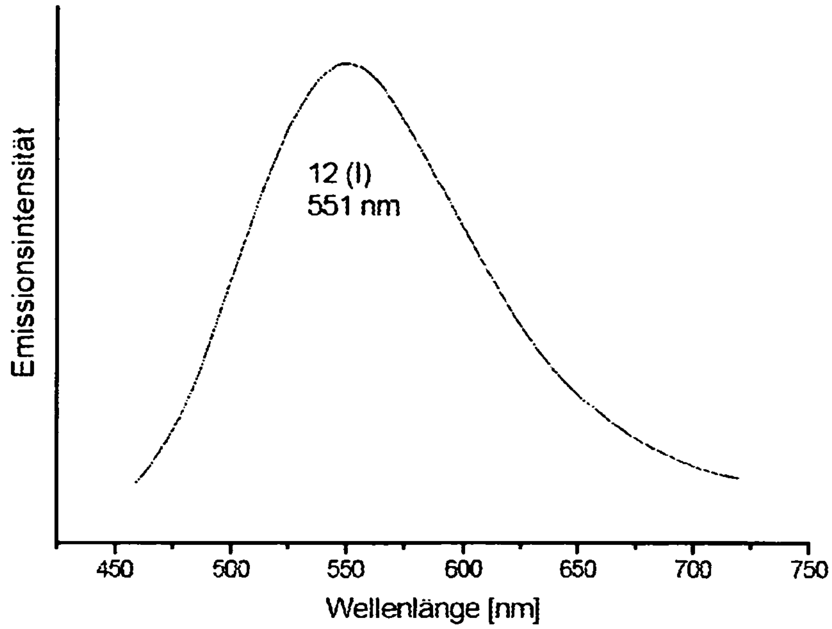
Emissionsintensität
12 (I)
551 nm
450
500
550
600
650
700
750
Wellenlänge [nm]

Fig. 17

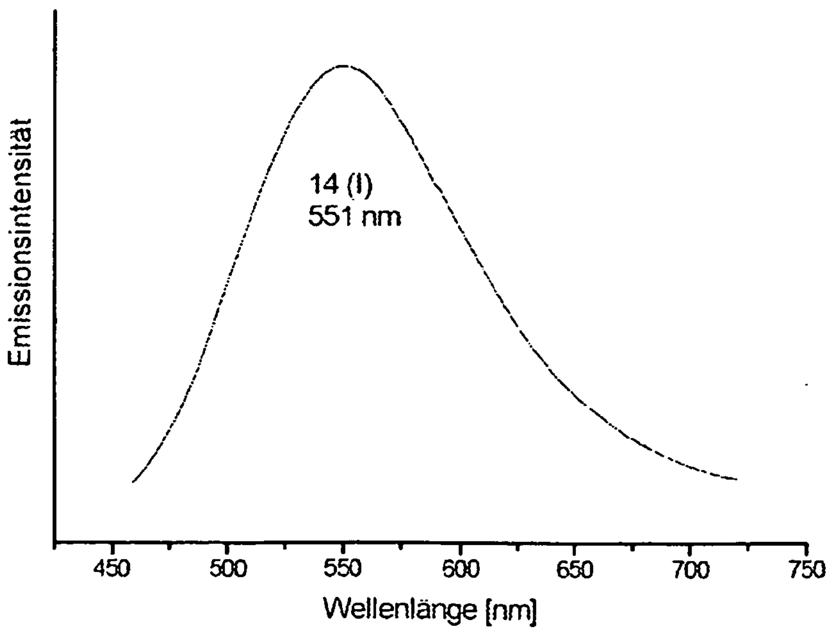
Emissionsintensität
14 (I)
551 nm
450
500
550
600
650
700
750
Wellenlänge [nm]

Fig. 18

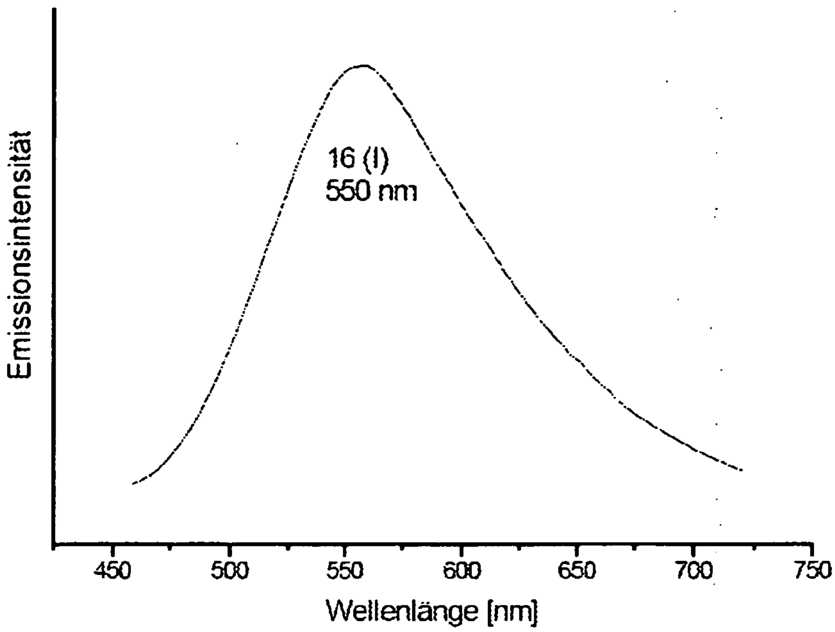
16 (I)
550 nm
Emissionsintensität
450
500
550
600
650
700
750
Wellenlänge [nm]

Fig. 19

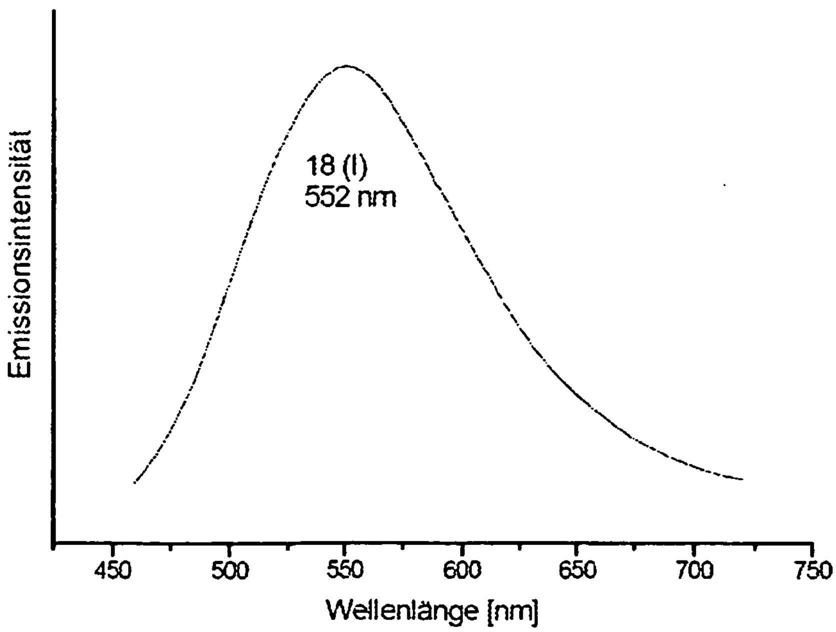
18 (I)
552 nm
Emissionsintensität
450
500
550
600
650
700
750
Wellenlänge [nm]

Fig. 20 A

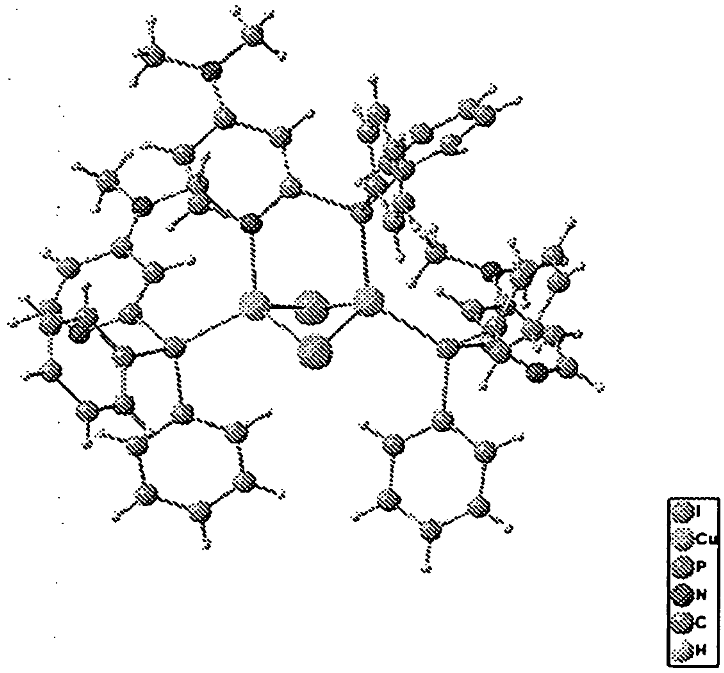


Fig. 20 B

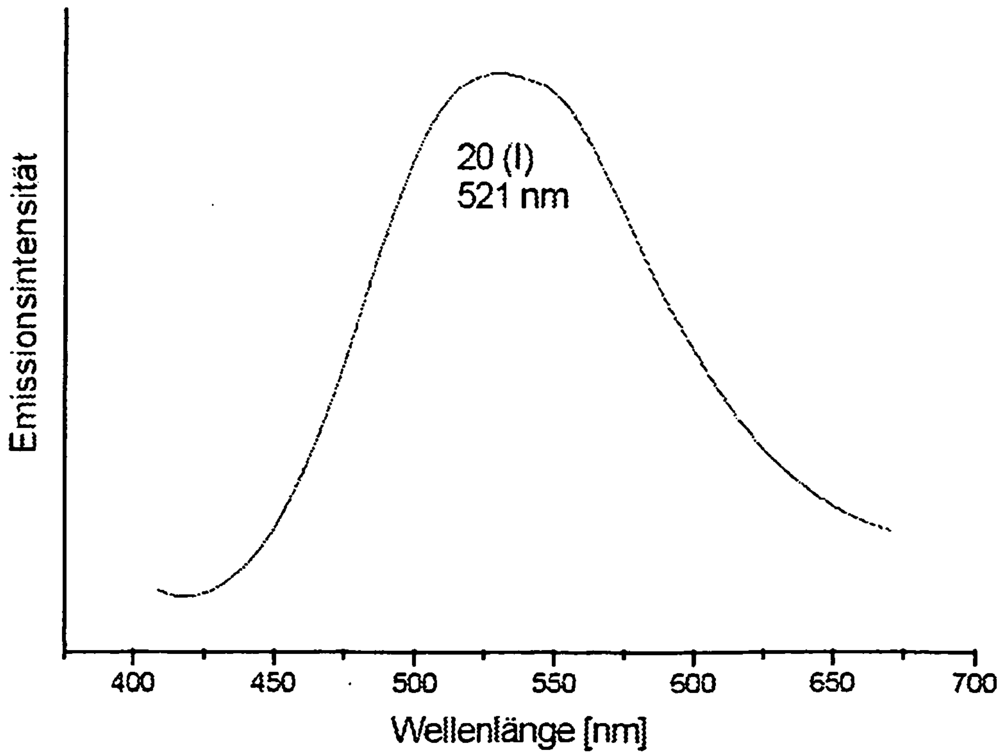

Fig. 21 A

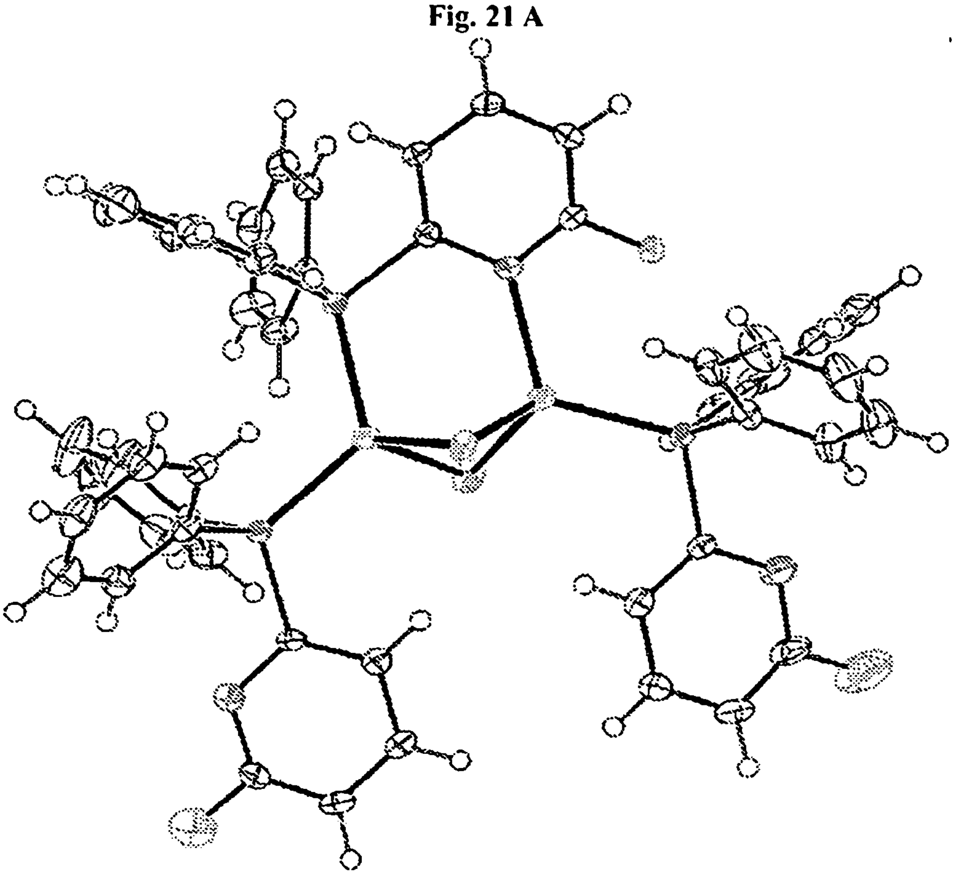

Fig. 21 B

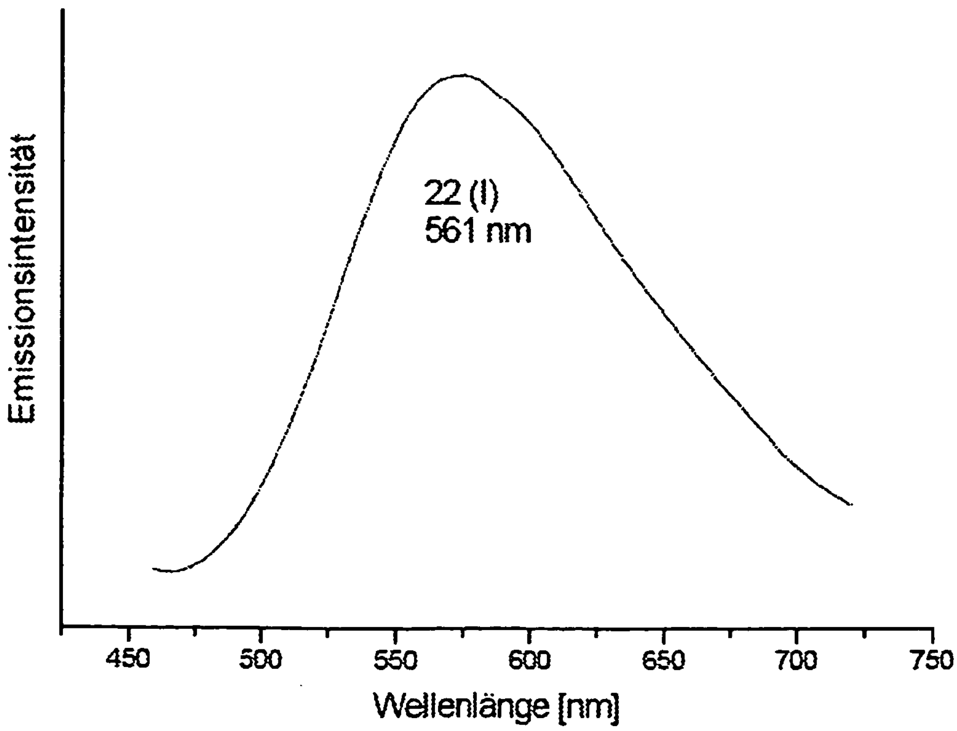

Fig. 22 A

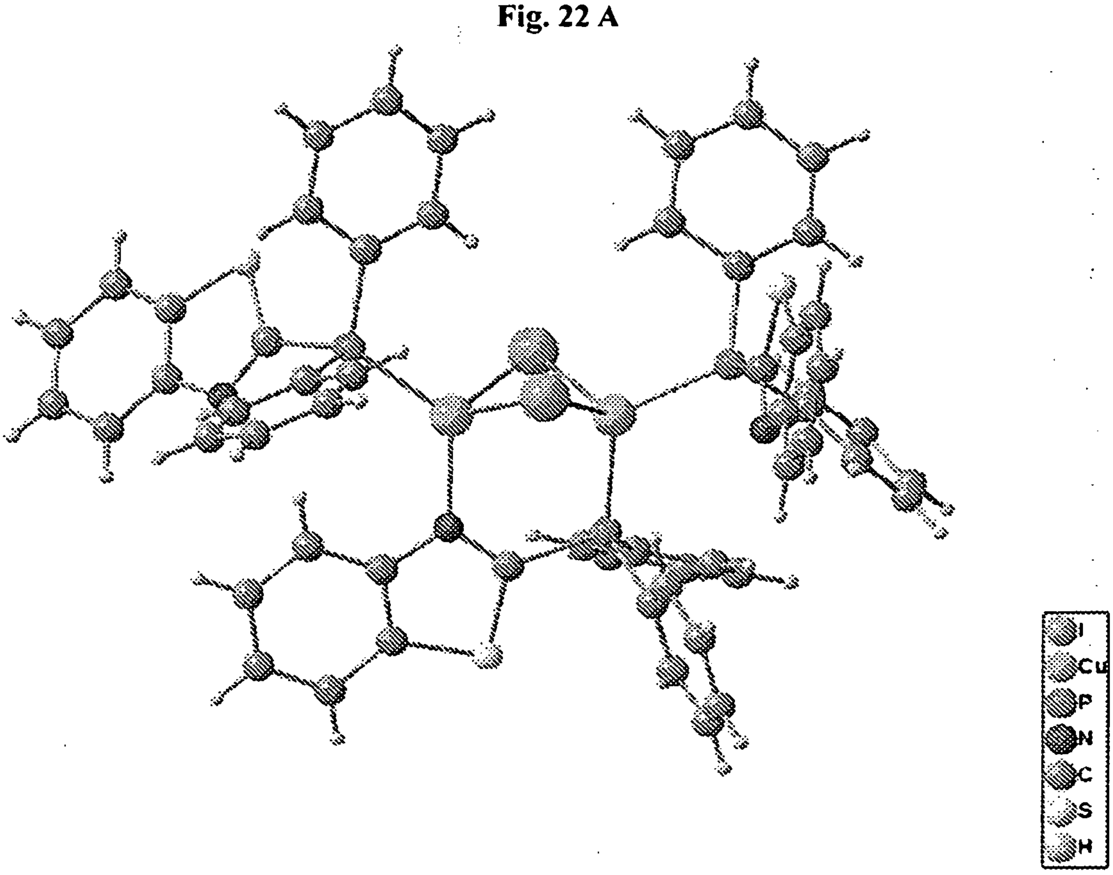

Fig. 22B

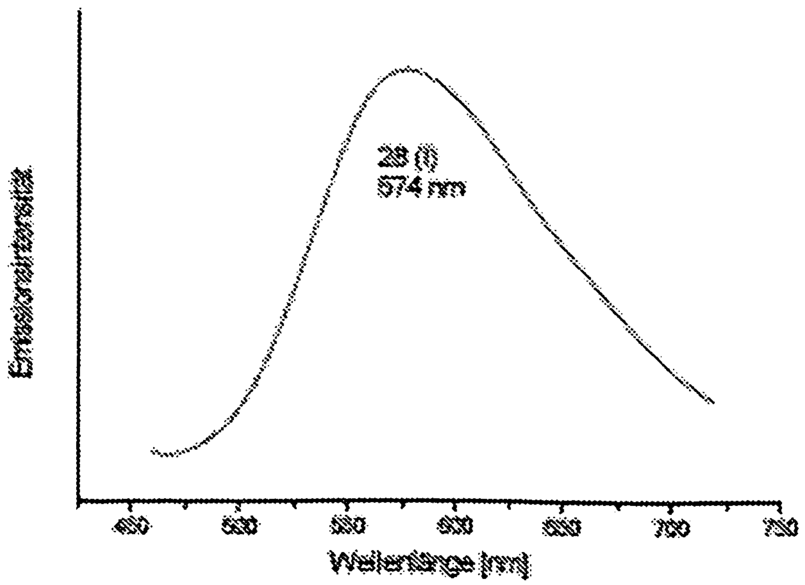

Fig 23

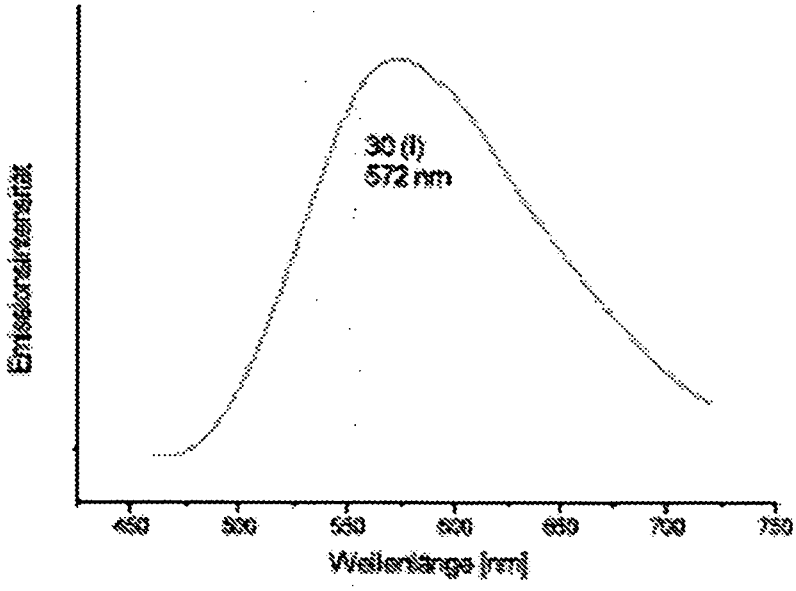
30 (I)
572 nm
Emissionsintensität
450
500
550
600
650
700
750
Wellenlänge [nm]

Fig. 24

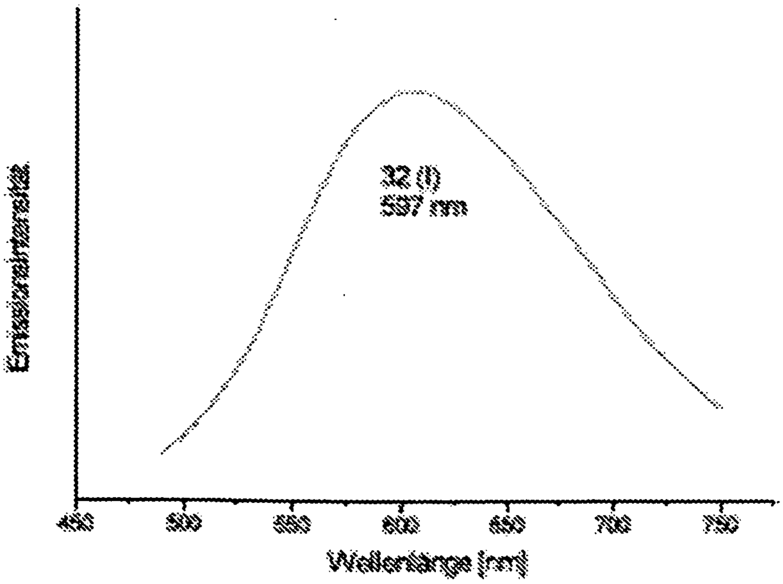
32 (I)
597 nm
Emissionsintensität
500
550
600
650
700
750
Wellenlänge [nm]

**Fig. 25**

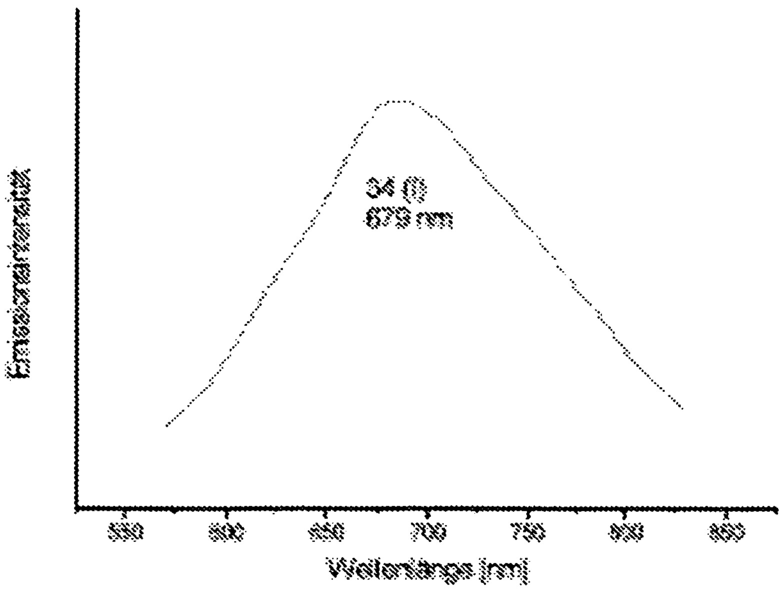
Emissionsintensität
34 (I)
679 nm
550
600
650
700
750
800
850
Wellenlänge [nm]

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente


- WO 2004017043 A2
- WO 2004016711 A1
- WO 03095587 A1
- US 20030205707 A1, C.-M. Che
- US 20020179885 A1, C.-M. Che, W. Lu, M. C.-W. Chan
- US 2003186080 A1, J. Kamatani, S. Okada, A. Tsuboyama, T. Takiguchi, S. Igawa
- DE 10350606 A1
- DE 10338550 A1
- DE 10358665 A1
- US 2006989273 B2
- WO 2006003000 A1
- WO 2006032449 A1
- WO 2006028546 A1


### In der Beschreibung aufgeführte Nicht-Patentliteratur


- **C. ADACHI ; M. A. BALDO ; S. R. FORREST ; S. LAMANSKY ; M. E. THOMPSON ; R. C. KWONG.** *Appl. Phys. Lett.,* 2001, vol. 78, 1622
- **X. H. YANG ; D. C. MÜLLER ; D. NEHER ; K. MEERHOLZ.** *Adv. Mater.,* 2006, vol. 18, 948
- **X. H. YANG ; D. NEHER.** *Appl. Phys. Lett.,* 2004, vol. 84, 2476
- Organic light-emitting devices - A survey. AIP-Press, Springer, 2004
- **H. YERSIN.** *Top. Curr. Chem.,* 2004, vol. 241, 1
- **H. YERSIN.** Highly Efficient OLEDs with Phosphorescent Materials. Wiley-VCH, 2008
- **Z. H. KAFAFI.** Organic Electroluminescence. Taylor & Francis, 2005
- **P. C. FORD ; E. CARIATI ; J. BOURASSA.** *Chem. Rev.,* 1999, vol. 99, 3625
- **H. ARAKI ; K. TSUGE ; Y. SASAKI ; S. ISHIZAKA ; N. KITAMURA.** *Inorg. Chem.,* 2007, vol. 46, 10032
- **A. RÖSSLER ; G. SKILLAS ; S. E. PRATSINIS.** *Chemie in unserer Zeit,* 2001, vol. 35, 32
- **Y. SUN ; K. YE ; H. ZHANG ; J. ZHANG ; L. ZHAO ; B. LI ; G. YANG ; B. YANG ; Y. WANG ; S.-W. LAI.** *Angew. Chem.,* 2006, vol. 118, 5738
- **Y. CHEN ; J. F. GERALD ; L. T. CHADDERTON ; L. CHAFFRON.** *Appl. Phys. Lett.,* 1999, vol. 74, 2782